# EUROPEAN PATENT APPLICATION

(11) **EP 3 822 281 A1**
(43) Date of publication of application: **19.05.2021**
(21) Application number: 19209874.7
(22) Date of filing: 18.11.2019
(51) Int. Cl.: C07F 15/02, B01J 31/22, G03F 7/00, H01G 9/20

(54) **IRON N-HETEROCYCLIC CARBENE COMPOUNDS**

(71) Applicant: Wärnmark, Kenneth, 226 48 Lund (SE)
(72) Inventor: WÄRNMARK, Kenneth, 226 48 Lund (SE); PERSSON, Petter, 268 73 Billeberga (SE); GORDIVSKA, Olga, 247 56 Dalby (SE); PRAKASH, Om, 226 46 Lund (SE)
(74) Representative: AWA Sweden AB

(57) **Abstract**

The present invention provides novel iron N-heterocyclic carbene compounds of formula (I), devices comprising said compounds, and uses of said compound.

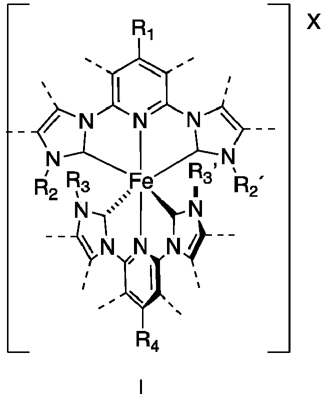

## Description

### Technical field of the Invention

The present invention relates to novel iron N-heterocyclic carbene compounds of formula (I), devices comprising said compounds, and uses of said compound.

### Background of the Invention

Continuous industrial growth requires an ever-increasing amount of energy and has an enormous impact on the levels of "greenhouse gases" (such as carbon dioxide, methane, nitrous oxide, and others) in the atmosphere, causing unprecedentedly high terrestrial temperature rise. Current trends in worldwide energy source distribution are dominated by non-renewable sources of energy. Considering the firmly established connection between the global climate change and CO₂ emissions, it is essential to diminish the use of the fossil fuels and switch to more environmentally friendly technology based on renewable energy sources. The sun is one of the cleanest and most abundant sources of energy. Regardless of the extensive progress in solar energy technology, it is still very immature and more substantial improvements, such as lower cost and higher efficiency, are desperately needed in order to compete with fossil fuels. The development of the DSSC (Dye Sensitized Solar Cells) technology, is a major research area for scientists working in the field of renewable energy.

Ruthenium-based complexes have been the major photosensitizers (PSs) in DSSCs, having an optimal disposition of Molecular Orbitals (MO). Nevertheless, major liabilities, such as scarcity and cost-inefficiency, has provoked vigorous search for a substitute.

Iron is an attractive substance due to its abundance and the orbital properties it shared with Ru. However, all iron-based polypyridine complexes suffer from ultra-short lived (femtosecond timescale) photoactive Triplet Metal-to-Ligand Charge-Transfer (³MLCT) state due to an intersystem crossing into another excited configuration with orbitals localized on a metal center (⁵MC). Because long-excited charge-transfer lifetimes are necessary for photofunctional applications, this prevents iron-based polypyridine complexes from being used in solar energy harvesting applications, such as photosensitizers.

To conclude, there is still a need for new compounds or photosensitizers which have improved properties as photosensitizer compared to known iron-based polypyridine complexes.

### Summary of the Invention

An object of the present invention is to fulfill the above-mentioned need. This object is reached with a compound of formula I: 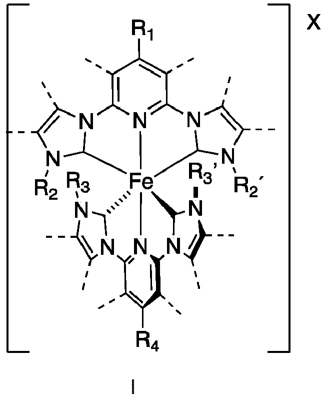 wherein
R₁ is independently selected from alkyl, alkenyl, alkynyl, aryl, heteroaryl, amino, alkoxy, aryloxy, heteroaryloxy, carbonyl, ester, or amide;
each R₂, R_{2'}, R₃, and R_{3'} are independently selected from straight alkyl, branched alkyl, aryl or heteroaryl;
R₄ is independently selected from alkyl, alkenyl, alkynyl, aryl, heteroaryl, amino, alkoxy, aryloxy, heteroaryloxy, carbonyl, ester, amide, carboxylic acid, phosphonic acid, cyanate or isocyanate, boronic acid; and anions or cations thereof;
X is selected from two mono-anions or one di-anions; preferably selected from (PF₆)₂, (BF₄)₂, (BPh₄)₂, SO₄; and
each dashed bond is independently selected from fused aryl; fused heteroaryl; or
substituent selected from hydrogen, alkyl, cyclyl, heterocyclyl, alkenyl, alkynyl, aryl, heteroaryl, amino, alkoxy, aryloxy, heteroaryloxy, carbonyl, ester, amide, carboxylic acid, nitro, or halogen.

Moreover, this object is also obtained with a device comprising the compound according to the present invention. One further aspect is also use of said compound with improved properties. The different aspects of the present invention appear in the independent claims, and further embodiments are disclosed in the accompanying dependent claims.

### Brief Description of the Drawings

Figure 1 shows X-ray of complex Example **5** according to the present invention.
Figure 2 shows differential pulse and cyclic voltammograms of examples according to the present invention in acetonitrile (0.1 M TBAPF₆); a) [Fe(L2)₂]²⁺ Example **4** (0.82 mM); b) [Fe(L1)(L2)]²⁺ Example **2** (1.62 mM); and c) [Fe(L1)(L3)]²⁺ Example **3** (1.45 mM).
Figure 3 shows spectroelectrochemistry of [Fe(L2)₂]²⁺ Example **4** according to the present invention; a) oxidation at 0.5 V; and b) oxidation at 1.3 V.
Figure 4 shows spectroelectrochemistry of [Fe(L2)₂]²⁺ Example **2** according to the present invention; a) oxidation at 0.5 V; and b) oxidation at 1.3 V.
Figure 5 shows spectroelectrochemistry of [Fe(L2)₂]²⁺ Example **3** according to the present invention; oxidation at 0.5 V.
Figure 6 shows a compilation of the frontier molecular orbitals for Examples **2-5** according to the present invention together with Compound **1,** in their respective ground states.
Figure 7 shows transient absorption spectra (a) and kinetics (b) of Examples **2, 3, 4** and **5** according to the present invention in acetonitrile solution, and Examples **2** and **3** on TiO₂.
Figure 8 shows the J-V (current-voltage) curve for the laboratory solar cell using reference Compound **1** and Example **2** according to the present invention, respectively, as photosensitizer.
Figure 9 shows the IPCE (incident photon-to electron conversion efficiency) curve for the laboratory solar cell using reference Compound **1** and Example **2** according to the present invention, respectively, as photosensitizer.

### Detailed description of Preferred Embodiments

Below some definitions of some terms and expressions used throughout the application text are presented.

The term "semiconductor" is a material that has an electrical conductivity value falling between that of a conductor, such as metallic copper, and an insulator, such as glass. The electrical properties of a semiconductor material can be modified by doping, or by the application of electrical fields or light. Further, devices made from semiconductors can be used for amplification, switching, and energy conversion.

The term "doping" generally means to alter the conduction properties of a semiconductor by introducing impurities into the crystal structure. Where two differently-doped regions exist in the same crystal, a semiconductor junction is created.

The term "photovoltaic device" is understood to mean a solar cell, or photovoltaic cell, which is an electrical device that converts the energy of light directly into electricity by the photovoltaic effect, which is a physical and chemical phenomenon. It is a form of photoelectric cell, defined as a device whose electrical characteristics, such as current, voltage, or resistance, vary when exposed to light. Individual solar cell devices can be combined to form modules, otherwise known as solar panels. Solar cells are described as being photovoltaic, irrespective of whether the source is sunlight or an artificial light. In addition to producing energy, photovoltaics can be used as photodetectors, e.g. infrared detectors, detecting light or other electromagnetic radiation near the visible range, or measuring light intensity. Traditional solar cells operate within the concept of p-n junction, meaning the solar cell consist of two types of semiconductors: one part of it may be crystalline silicon (IV group element) doped with elements of group V (n-type semiconductor with additional levels of free electrons in the conduction band), the other part may be crystalline silicon doped with elements of group III (p-type semiconductor, which adds extra holes to the conduction band). When those two crystal types are in contact electrons from the n-side flow to the p-side to equalize the Fermi levels. The introduction of p/n-type additives significantly affects the band gap and thus makes it more isoenergetic to the sunlight.

The term "donor or "donor substituent" and "acceptor" or "acceptor substituent", respectively, is understood to mean donor and acceptor of electrons, and compound, complexes or moieties being able to donate or accept electrons, respectively.

The term "pi-donor" or "pi-acceptor" is understood to mean moieties that can donate or accept electrons through their pi-systems.

The term "bis-aryl amino groups" is understood to comprise two aromatic species (identical or different) attached to an amino group attached in turn to a ligand that is connected to the iron core.

The term "homoleptic" compound or complex is understood to mean a metal compound or complex wherein all its ligands are identical. Thus, a metal compound or complex which has more than one type of ligand is "heteroleptic".

The term "ligand" is understood to mean an ion or molecule or functional group, that binds to a central metal atom to form a coordination complex. The bonding with the metal generally involves formal donation of one or more of the ligand's electron pairs. The nature of metal-ligand bonding may be covalent or ionic. Furthermore, the metal-ligand bond order can range from one to three.

The term "alkyl" means both straight and branched chain saturated hydrocarbon groups as well as cyclic hydrocarbons. Examples of alkyl groups include, but are not limited to, methyl, ethyl, n-propyl, iso-propyl, n-butyl, t-butyl, iso-butyl, and sec-butyl groups. In the present application the term "(C₁-C₂₄)alkyl" means an alkyl chain, straight or branched, comprising between 1-24 carbon atoms. Examples of unbranched alkyl groups are methyl, ethyl, n-propyl, and n-butyl groups. More specifically the alkyl group is methyl. Among branched alkyl groups, there may be mentioned iso-propyl, t-butyl, iso-butyl, and sec-butyl groups. Further, there is the option that the alkyl groups of the present invention are cyclic alkyl or cyclyl groups, such as cyclopropyl, cyclobutyl, cyclopentyl, cyclohexyl. In the present application the term "(C₃-C₆)cyclyl" means a cyclic hydrocarbon comprising between 3-6 carbon atoms.. Further, the alkyl and cyclyl groups may be optionally substituted by one or more substituents selected from hydroxy, halogen, cyano, nitro, amino, amide, ester, alkyl, alkoxy, aryl, heteroaryl, aryloxy, heteroaryloxy, if not otherwise specified.

The term "alkoxy" means the group O-alkyl, where "alkyl" is used as described above. Examples of alkoxy groups include, but are not limited to, methoxy and ethoxy groups. Other examples include propoxy and butoxy, such as iso-propoxy, n-propoxy, *tert-*butoxy, *iso*-butoxy and *sec*-butoxy. The oxygen atom is directly attached to the structural motif in question. Similarly, the terms "aryloxy" and "heteroaryloxy" means the group O-aryl and O-heteroaryl, respectively, where "aryl" and "heteroaryl" are used as described below.

The term "alkenyl" means a group containing a double bond directly attached to the structural motif in question. Alkenyls of the present invention may be cis- or trans-substitued.

The term "alkynyl" means a group containing a triple bond and that the triple bond part is directly attached to the structural motif in question. Examples of alkenyl and alkynyl groups include, but are not limited to, CHCH₂ or CHCHR' and CCH or CCR', respectively. The alkenyl and alkynyl groups may also form repetitive units in a larger conjugated system, wherein the conjugated system may include, but is not limited to, alternating double or tipple bonds or combinations thereof. Further, the alkenyl and alkynyl groups may be optionally substituted by one or more substituents selected from hydroxy, halogen, cyano, nitro, amino, amide, ester, alkyl, alkoxy, aryl, heteroaryl, aryloxy, heteroaryloxy, if not otherwise specified.

The terms "aryl" and "heteroaryl" means a group containing an aromatic or heteroaromatic moiety, where the aromatic or heteroaromatic moiety is directly attached to the structural motif in question. Examples of aryl group include, but are not limited to, phenyl, naphthyl, anthryl, phenanthrene or pyrene. In the present application the term "(C₆-C₂₄)aryl" means an aromatic group comprising between 6-24 carbon atoms, thus ranging from phenyl comprising 6 carbon atoms to larger fused aromatic systems, for example coronene comprising 24 carbon atoms. Examples of heteroaryl groups include, but are not limited to, five- to twelve-membered heterocyclic groups containing one or more heteroatoms selected from oxygen, nitrogen and sulfur. More specific examples of heteroaryl groups include, but are not limited to, pyridinyl, pyrimidinyl, pyrazinyl, pyrrolyl, thienyl, thiophenyl, furanyl, imidazolyl, oxazolyl, thiazolyl, thiadiazolyl and fused analogues thereof. In the present application the term "(C₃-C₂₀)heteroaryl" means an heteroaromatic group comprising between 3-20 carbon atoms. Heteroatoms of the heteroaryl may be selected from nitrogen, oxygen, sulfur, and selenium. The aryl and heteroaryl groups may be optionally substituted by one or more substituents selected from hydroxy, halogen, cyano, nitro, amino, amide, ester, alkyl, alkoxy, aryl, heteroaryl, aryloxy, heteroaryloxy, if not otherwise specified.

The term "heterocyclyl" means a cyclic group of carbon atoms wherein from one to three of the carbon atoms is/are replaced by one or more heteroatoms independently selected from nitrogen, oxygen, and sulfur. Examples of heterocyclyl groups include, but are not limited to, tetrahydrofuranyl, pyrrolidinyl, piperidinyl, piperazinyl, morpholinyl, dioxanyl. and the like. In the present application the term "(C₂-C₅)heterocyclyl" means an heterocyclic group comprising between 2-5 carbon atoms.

The term "amino" means a group containing a central nitrogen atom to which one or two hydrogen(s), alkyl, aryl or heteroaryl groups have been attached and nitrogen atom is directly attached to the structural motif in question. In the present application the amino group include, but is not limited to, NH₂, NH(C₁-C₂₄)alkyl, and N[(C₁-C₂₄)alkyl]₂, NH(C₆-C₂₄)aryl, N[(C₆-C₂₄)aryl]₂, NH(C₃-C₂₀)heteroaryl, N[(C₃-C₂₀)heteroaryl]₂.

The term "fused ring system" means a ring system where the two ends of the ring in question is connected to the same structural moiety in question, however, not to the same atom of the latter.

According to a first aspect the present invention relates to a compound of formula I: 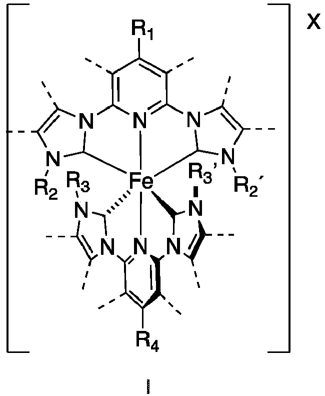 wherein
R₁ is independently selected from alkyl, alkenyl, alkynyl, aryl, heteroaryl, amino, alkoxy, aryloxy, heteroaryloxy, carbonyl, ester, or amide;
each R₂, R_{2'}, R₃, and R_{3'} are independently selected from straight alkyl, branched alkyl, aryl or heteroaryl;
R₄ is independently selected from alkyl, alkenyl, alkynyl, aryl, heteroaryl, amino, alkoxy, aryloxy, heteroaryloxy, carbonyl, ester, amide, carboxylic acid, phosphonic acid, cyanate or isocyanate, boronic acid; and anions or cations thereof;
X is selected from two mono-anions or one di-anions; preferably selected from (PF₆)₂, (BF₄)₂, (BPh₄)₂, SO₄; and
each dashed bond is independently selected from fused aryl; fused heteroaryl; or
substituent selected from alkyl, cyclyl, heterocyclyl, alkenyl, alkynyl, aryl, heteroaryl, amino, alkoxy, aryloxy, heteroaryloxy, carbonyl, ester, amide, carboxylic acid, nitro, or halogen. In the present invention, when alkyls are included, such as when R₁, R₂, R_{2'}, R₃, R_{3'}, or R₄ represents alkyl it may be a methyl, ethyl, *n*-propyl, *i*-propyl, *n*-butyl, *n*-pentyl, *n*-hexyl, *n-*octyl, *n*-nonane, *n*-decane, *n*-undecane, *n*-dodecane, *n*-hexadecane, *n*-octadecane, *n-*icosane, or *n*-tetracosane. Further, in the present invention, when aryls are included, such as when R₁, R₂, R_{2'}, R₃, R_{3'}, or R₄ represents aryl it may be an optionally substituted phenyl, naphthyl, or anthryl. Furthermore, in the present invention, when heteroaryls are included, such as when R₁, R₂, R_{2'}, R₃, R_{3'}, or R₄ represents heteroaryl it may be an optionally substituted pyridinyl, pyrimidinyl, pyrazinyl, pyrrolyl, thienyl, thiophenyl, furanyl, imidazolyl, oxazolyl, thiazolyl, or thiadiazolyl. When R₁ or R₄ represents an amino, alkoxy, aryloxy, or heteroaryloxy, it means that the oxygen or nitrogen may also be substituted with the alkyls, aryls, or heteroaryls as presented above.
In one embodiment of this aspect, R₁ represents 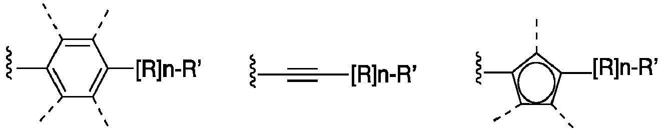 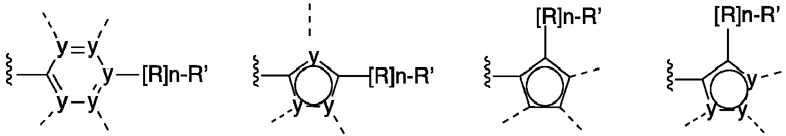 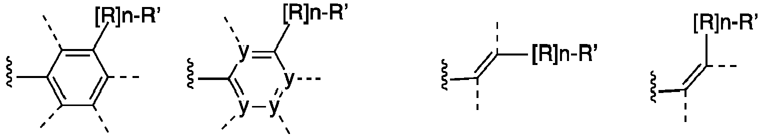 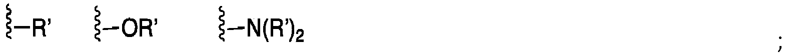
R' is independently selected from alkyl, alkenyl, alkynyl, aryl, heteroaryl, amino, alkoxy, aryloxy, heteroaryloxy, carbonyl, ester, or amide;
R₄ represents 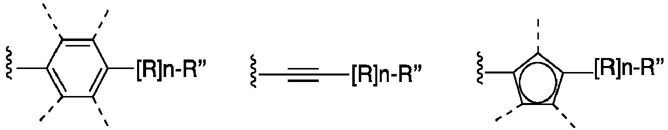 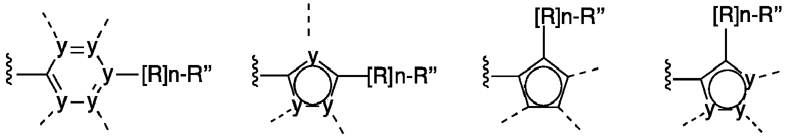 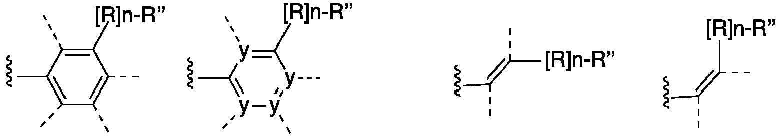 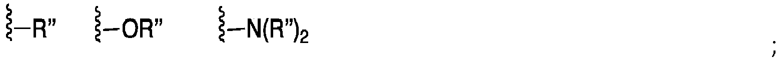
R" is independently selected from alkyl, alkenyl, alkynyl, aryl, heteroaryl, amino, alkoxy, aryloxy, heteroaryloxy, carbonyl, ester, amide, carboxylic acid, phosphonic acid, cyanate or isocyanate, boronic acid; and anions or cations thereof;
n is an integer number between 0-24 of optionally selected R;
R is optionally selected from 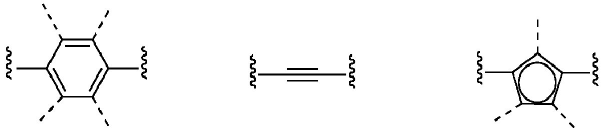 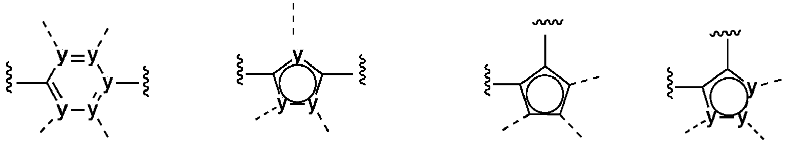 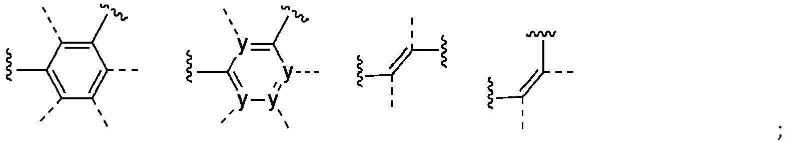
each wavy line denotes connection points to other optionally selected R, R' or R";
each dashed bond is independently selected from fused aryl; fused heteroaryl; or substituent selected from hydrogen, alkyl, cyclyl, heterocyclyl, alkenyl, alkynyl, aryl, heteroaryl, amino, alkoxy, aryloxy, heteroaryloxy, carbonyl, ester, amide, carboxylic acid, nitro, or halogen; and
y is independently selected from C, N, O, S and Se.
In the present invention n describes the number of repeating R-groups, wherein the R-group may differ for each increasing n. Thus, n may comprise, but is not limited to, one single R-group. In one embodiment of this aspect, R₁, R₄, or R₁ and R₄, may comprise R-groups comprising phenyl, alkenyl, or alkynyl. In one embodiment of this aspect, R₁, R₄, or R₁ and R₄, may comprise two different R-groups. In one embodiment of this aspect, R₁, R₄, or R₁ and R₄, may comprise R-groups comprising phenyl and alkenyl, or phenyl and alkynyl, which may be connected to each other in a random order. In different embodiments of this aspect n may be 0, 1, 2, 3, 4, 5, 6, 7, 8, 9, 10, 11, 12, 13, 14, 15, 16, 17, 18, 19, 20, 21, 22, 23, or 24. Further, in embodiments of the present invention, when alkyls are included, such as when R' or R" represents alkyl it may be a methyl, ethyl, *n*-propyl, *iso*-propyl, *n*-butyl, *sec-*butyl, *iso*-butyl, *tert*-butyl, *n*-pentyl, *n*-hexyl, *n*-octyl, *n*-nonane, *n*-decane, *n*-undecane, *n*-dodecane, *n-*hexadecane, *n*-octadecane, *n*-icosane, or *n*-tetracosane. Further, in the present invention, when aryls are included, such as when R' or R" represents aryl it may be an optionally substituted phenyl, naphthyl, or anthryl. Furthermore, in the present invention, when heteroaryls are included, such as when R' or R" represents heteroaryl it may be an optionally substituted pyridinyl, pyrimidinyl, pyrazinyl, pyrrolyl, thienyl, thiophenyl, furanyl, imidazolyl, oxazolyl, thiazolyl, or thiadiazolyl. When R' or R" represents an amino, alkoxy, aryloxy, or heteroaryloxy, it means that the oxygen or nitrogen may also be substituted with the alkyls, aryls, or heteroaryls as presented above. In one embodiment of this aspect, R' may be selected from N(p-methylphenyl)₂ and N(p-methoxyphenyl)₂. In another embodiment of this aspect, R" may be selected from CO₂H. In another embodiment of this aspect, R' may be selected from N(p-methylphenyl)₂ and R" may be selected from CO₂H. In another embodiment of this aspect, R' may be selected from N(p-methoxyphenyl)₂ and R" may be selected from CO₂H.

In another embodiment of this aspect, R₁ represents 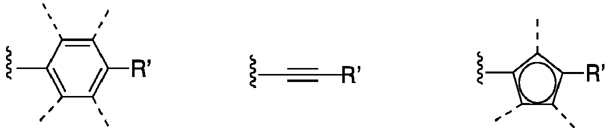 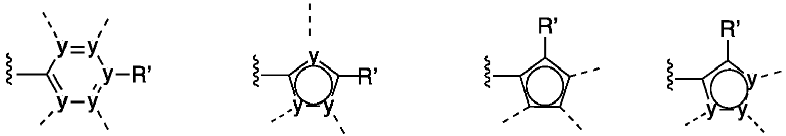 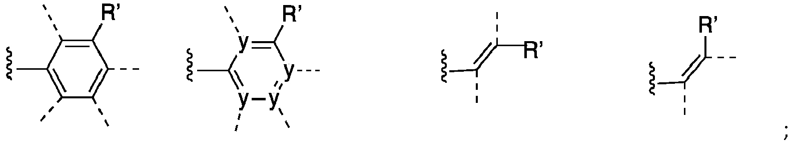
R' is independently selected from alkyl, alkenyl, alkynyl, aryl, heteroaryl, amino, alkoxy, aryloxy, heteroaryloxy, carbonyl, ester, or amide;
each dashed bond is independently selected from fused aryl; fused heteroaryl; or substituent selected from hydrogen, alkyl, cyclyl, heterocyclyl, alkenyl, alkynyl, aryl, heteroaryl, amino, alkoxy, aryloxy, heteroaryloxy, carbonyl, ester, amide, carboxylic acid, nitro, or halogen; and
y is independently selected from C, N, O, S and Se.

In another embodiment of this aspect, R₄ represents 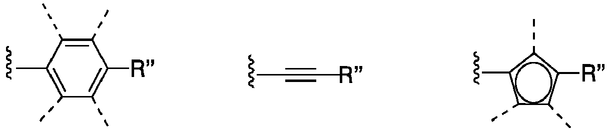 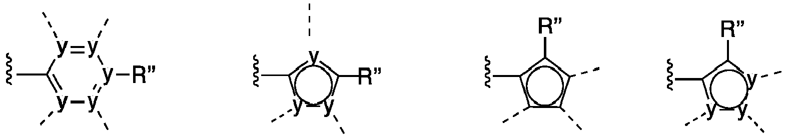 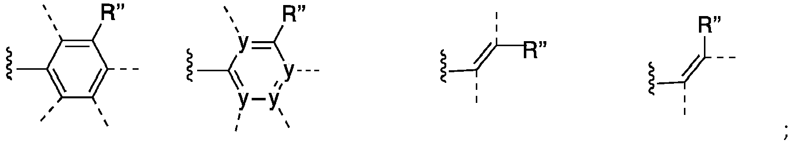
R" is independently selected from alkyl, alkenyl, alkynyl, aryl, heteroaryl, amino, alkoxy, aryloxy, heteroaryloxy, carbonyl, ester, amide, carboxylic acid, phosphonic acid, cyanate or isocyanate, boronic acid; and anions or cations thereof;
each dashed bond is independently selected from fused aryl; fused heteroaryl; or substituent selected from hydrogen, alkyl, cyclyl, heterocyclyl, alkenyl, alkynyl, aryl, heteroaryl, amino, alkoxy, aryloxy, heteroaryloxy, carbonyl, ester, amide, carboxylic acid, nitro, or halogen; and
y is independently selected from C, N, O, S and Se.

In another embodiment of this aspect, R₁ represents 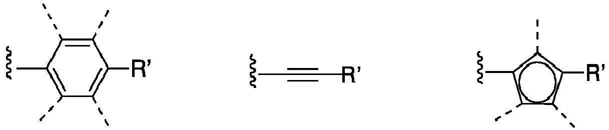 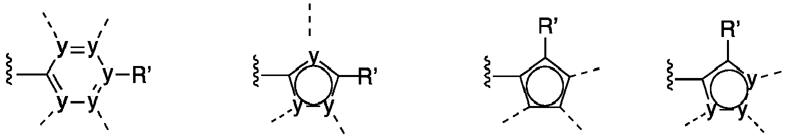 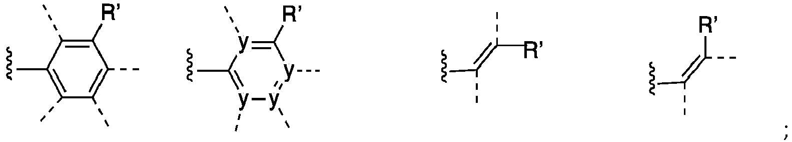
R' is independently selected from alkyl, alkenyl, alkynyl, aryl, heteroaryl, amino, alkoxy, aryloxy, heteroaryloxy, carbonyl, ester, or amide;
R₄ represents 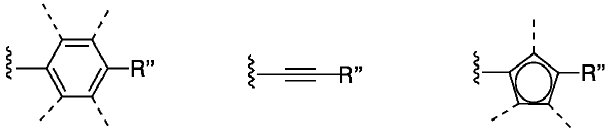 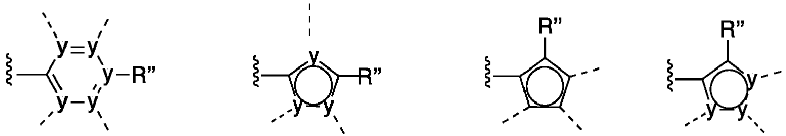 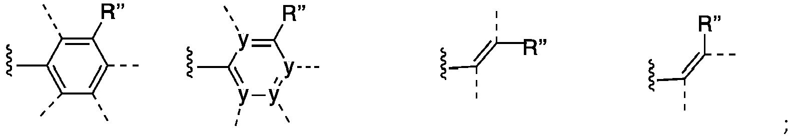
R" is independently selected from alkyl, alkenyl, alkynyl, aryl, heteroaryl, amino, alkoxy, aryloxy, heteroaryloxy, carbonyl, ester, amide, carboxylic acid, phosphonic acid, cyanate or isocyanate, boronic acid; and anions or cations thereof;
each dashed bond is independently selected from fused aryl; fused heteroaryl; or substituent selected from hydrogen, alkyl, cyclyl, heterocyclyl, alkenyl, alkynyl, aryl, heteroaryl, amino, alkoxy, aryloxy, heteroaryloxy, carbonyl, ester, amide, carboxylic acid, nitro, or halogen; and
y is independently selected from C, N, O, S and Se.

In another embodiment of this aspect, R₁ is selected from optionally substituted (C₁-C₂₄)alkyl, alkenyl, alkynyl, (C₆-C₂₄)aryl, (C₃-C₂₀)heteroaryl, O(C₁-C₂₄)alkyl, O(C₆-C₂₄)aryl, O(C₃-C₂₀)heteroaryl, NH(C₁-C₂₄)alkyl, and N[(C₁-C₂₄)alkyl]₂, NH(C₆-C₂₄)aryl, N[(C₆-C₂₄)aryl]₂, NH(C₃-C₂₀)heteroaryl, N[(C₃-C₂₀)heteroaryl]₂; preferably R₁ is selected from methyl, ethyl, propyl, methoxy, ethoxy, phenoxy, NHmethyl, N(methyl)₂, NHphenyl, N(phenyl)₂, NH(p-methylphenyl), N(p-methylphenyl)₂, NH(p-methoxyphenyl), N(p-methoxyphenyl)₂.

In another embodiment of this aspect, R₄ is selected from carboxylic acid, phosphonic acid, cyanate or isocyanate, boronic acid; and anions or cations thereof. The R₄-groups have the advantage of offering physical and chemical characteristics, such as being an anchor group, meaning that they may form a conjugate or an interface between the compound, or Fe-NHC complex, to a metal oxide surface or particle. In one embodiment the R₄-groups represents anchors for TiO₂.

In another embodiment of this aspect, R₁ is selected from optionally substituted (C₁-C₂₄)alkyl, alkenyl, alkynyl, (C₆-C₂₄)aryl, (C₃-C₂₀)heteroaryl, O(C₁-C₂₄)alkyl, O(C₆-C₂₄)aryl, O(C₃-C₂₀)heteroaryl, NH(C₁-C₂₄)alkyl, and N[(C₁-C₂₄)alkyl]₂, NH(C₆-C₂₄)aryl, N[(C₆-C₂₄)aryl]₂, NH(C₃-C₂₀)heteroaryl, N[(C₃-C₂₀)heteroaryl]₂; and; and R₄ is selected from carboxylic acid, phosphonic acid, cyanate or isocyanate, boronic acid; and anions or cations thereof.

In another embodiment of this aspect, R₁ is selected from optionally substituted methyl, ethyl, propyl, methoxy, ethoxy, phenoxy, NHmethyl, N(methyl)₂, NHphenyl, N(phenyl)₂, NH(p-methylphenyl), N(p-methylphenyl)₂, NH(p-methoxyphenyl), N(p-methoxyphenyl)₂; and R₄ is selected from carboxylic acid or phosphonic acid; and anions or cations thereof.

In another embodiment of this aspect, R₁ is selected from optionally substituted N[(C₆-C₂₄)aryl]₂; and R₄ is selected from carboxylic acid or phosphonic acid; and anions or cations thereof.
In another embodiment of this aspect, R₁ represents optionally substituted N[(C₆-C₂₄)aryl]₂.
In another embodiment of this aspect, R₁ is N(p-methylphenyl)₂ or N(p-methoxyphenyl)₂.
In another embodiment of this aspect, R₄ is CO₂H.
In another embodiment of this aspect, R₂ and R_{2'} represents methyl, ethyl, *n*-propyl, *i-*propyl, *n*-butyl, *n*-pentyl, *n*-hexyl, *n*-octyl, *n*-nonane, *n*-decane, *n*-undecane, *n*-dodecane, *n-*hexadecane, *n*-octadecane, *n*-icosane, *n*-tetracosane, optionally substituted phenyl.
In another embodiment of this aspect, R₂ and R_{2'} is selected from methyl or optionally substituted phenyl.
In another embodiment of this aspect, R₂ and R_{2'} represents methyl.
In another embodiment of this aspect, R₂ and R_{2'} is selected from p-methylphenyl or p-methoxyphenyl.
In another embodiment of this aspect, R₃ and R_{3'} represents methyl, ethyl, *n*-propyl, *i-*propyl, *n*-butyl, *n*-pentyl, *n*-hexyl, *n*-octyl, *n*-nonane, *n*-decane, *n*-undecane, *n*-dodecane, *n-*hexadecane, *n*-octadecane, *n*-icosane, or *n*-tetracosane.
In another embodiment of this aspect, R₃ and R_{3'} represents methyl.
In another embodiment of this aspect, R₃ and R_{3'} is selected from p-methylphenyl or p-methoxyphenyl.
In another embodiment of this aspect, R₂, R_{2'}, R₃, and R_{3'} represents methyl.
In another embodiment of this aspect, said dashed bond is hydrogen.
In another embodiment of this aspect, R₁ represents an electron donating group.
In another embodiment of this aspect, R₄ represents an electron accepting group.
In another embodiment of this aspect, R₁ represents an electron donating group and R₄ represents an electron accepting group.

In another aspect of the invention, there is provided a compound of formula I, wherein said compound is (2,6-Bis(3-methylimidazol-2-idene-1-yl)-pyridine-4-carboxylicacid)(2,6-bis(3-methylimidazol-2-idene-1-yl)-N, N-di-p-tolyl-pyridine-amine)iron(II) hexafluorophosphate or (2,6-Bis(3-methylimidazol-2-idene-1-yl)-pyridine-4-carboxylic acid)(N,N-bis(4-methoxyphenyl)-2,6-bis-(3-methylimidazol-2-idene-1-yl)-pyridine-amine)iron(II)hexafluorophosphate.

In another aspect of the invention, there is provided a compound of formula I, wherein said compound is bis(2,6-bis(3-methylimidazol-2-idene-1-yl)-N,N-di-p-tolyl-pyridine-amine)iron(II) hexafluorophosphate or bis(N,N-bis(4-methoxyphenyl)-2,6-bis-(3-methylimidazol-2-idene-1-yl)-pyridine-amine)iron(II) hexafluorophosphate.
In another aspect of the invention, there is provided a compound of formula I, wherein said compound is a photosensitizer and/or a photocatalyst. This means that the compound of the present invention may be a photosensitizer, or a photocatalyst, or a combined photosensitizer and photocatalyst.

In another aspect of the invention, there is provided a device comprising the compound according to the present invention. In one embodiment of this aspect, said compound is conjugated to a semiconducting surface or particle; preferably the semiconducting surface or particle is of TiO₂ or NiO; preferably the semiconducting surface or particle is of TiO₂; preferably the semiconducting surface is a flat surface of TiO₂.
In one embodiment of this aspect, said device may be a solar cell, water oxidation catalyst, proton reduction catalyst, carbon dioxide reduction catalyst, or photoredox catalyst.
In another embodiment of this aspect, said device may be a solar cell. The solar cell of the present invention may further comprise an electrolyte, wherein said electrolyte may be selected from triiodide or iodide, triphenanthrolinecobalt(III) (Co(phen)₃), or bis-(4,4',6,6'-tetramethyl-2,2'-bipyridine)copper(I) (Cu(tmby)₂).
In another embodiment of this aspect, said device may be a water oxidation catalyst.
In another embodiment of this aspect, said device may be a proton reduction catalyst.
In another embodiment of this aspect, said device may be a carbon dioxide reduction catalyst.
In another embodiment of this aspect, said device may be a photoredox catalyst.

In another aspect of the invention, there is provided use of a compound according the present invention in a solar cell, water oxidation catalyst, proton reduction catalyst, carbon dioxide reduction catalyst, or photoredox catalyst.
In one embodiment of this aspect, there is provided use a compound according the present invention in a solar cell.
In another embodiment of this aspect, there is provided use a compound according the present invention in a water oxidation catalyst.
In another embodiment of this aspect, there is provided use a compound according the present invention in a proton reduction catalyst.
In another embodiment of this aspect, there is provided use a compound according the present invention in a carbon dioxide reduction catalyst.
In another embodiment of this aspect, there is provided use a compound according the present invention in a photoredox catalyst.

### Dye-Sensitized Solar Cells

In order to reduce the production cost, thin film solar cell technologies emerged, most employing the sandwich-like structure that consists of two conductive glass plates and photoactive material between them. Dye-sensitized solar cells (DSSCs) are promising candidates for application in thin-film solar cells due to low manufacturing costs.

The typical DSSC consists of a sensitizer or dye covalently bound to the semiconductor surface, which may be n- or p- type, of the electrode surrounded by electrolyte. The semiconductor of the present invention may be TiO₂ and NiO, but is in no way restricted to these materials. The semiconductor may be any semiconducting surface och particle to which the compound or sensitizer molecule of the present invention may be conjugated or attached to. In a preferred embodiment the surface is a flat surface, i.e. a level surface without raised areas or indentations. The sensitizer molecule is a key component here, since the efficiency of the solar cell directly depends on its ability to absorb sunlight and to inject electrons or holes into the semiconductor, depending on its type, from its excited state. After charge carriers, i.e. electrons or holes, are injected into the semiconductor, the created electric current is collected at one of the electrodes, anode in case of electrons and cathode in case of holes, and then flows via an external circuit to the opposite electrode. The electrolyte include, but is not limited to, triiodide/iodide, triphenanthrolinecobalt(III) (Co(phen)₃), or bis-(4,4',6,6'-tetramethyl-2,2'-bipyridine)copper(I) (Cu(tmby)₂), is also an important part of the cell, which regenerates the oxidized or reduced dye.

### Design and Synthesis of the Ligands

To design the donor substituent, the attention was drawn to di-substituted amino groups which are common as a part of organic chromophores to enhance charge separation. Although bis-alkyl amino groups are known as the best pi-donors, their basicity creates a possibility for protonation, which can complicate the photophysics of the resulting sensitizers. In contrast, bis-aryl amino groups are a compromise between reasonable pi-donating strengths and an almost absent basicity, as the pKa of the conjugate acid of Ph₃N is reported as -3.91. By varying the substitution at the aryl group, fine-tuning of the electronic properties may be possible. Bis(*p*-tolyl)amino and bis(*p*-anisyl)amino groups were chosen to modulate the electron donating behavior, such as presented by ligands **L2** and **L3** of the present invention. Further, for the purpose of the present invention the other ligand of the heteroleptic complex should be an electron acceptor group. The other ligand shall also be suitable as anchor group. An example of acceptor group also being suitable anchor group is carboxylic acid group, which allows to attach the final complex to a semiconductor surface. Other examples of anchor groups may include, but are not limited to, pyridine, phosphonic acid, tetracyanate, perylene dicarboxylic acid anhydride, 2-hydroxybenzonitrile, 8-hydoxylquinoline, pyridine-N-oxide, hydroxylpyridinium, catechol, hydroxamate, sulfonic acid, acetylacetanate, boronic acid, nitro, tetrazole, rhodanine, and salicylic acid. For this purpose, the already reported ligand **L1** (2,6-bis(3-methylimidazolium-1-yl)pyridine-4-carboxylic acid hexafluorophosphate) ligand was chosen.

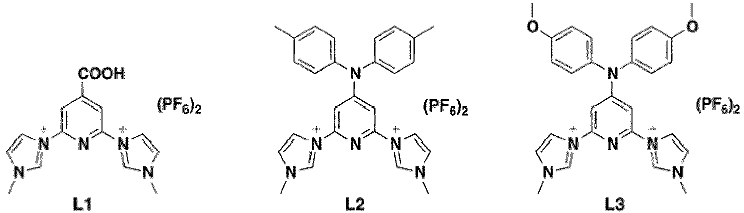

The best approach to the synthesis of the ligands containing amino-groups, such as **L2** and **L3,** is to introduce the substituent, such as alkyl, aryl or heteroaryl, of the imidazole, necessary for carbene formation, in the last step. Two possibilities were considered for making ligands precursor intermediate **6:** from intermediate **7** via coupling with two equivalents of aryl bromide; or from intermediate **9** via coupling with bis-aryl amine (scheme 1). The double C-N coupling was investigated first despite the lack of robust conditions in the literature, as the alternative route would require an additional Sandmeyer bromination step to make intermediate **9.** The key-intermediate **7** was planned to be synthesized via coupling of the commercially available precursor **8** with imidazole.

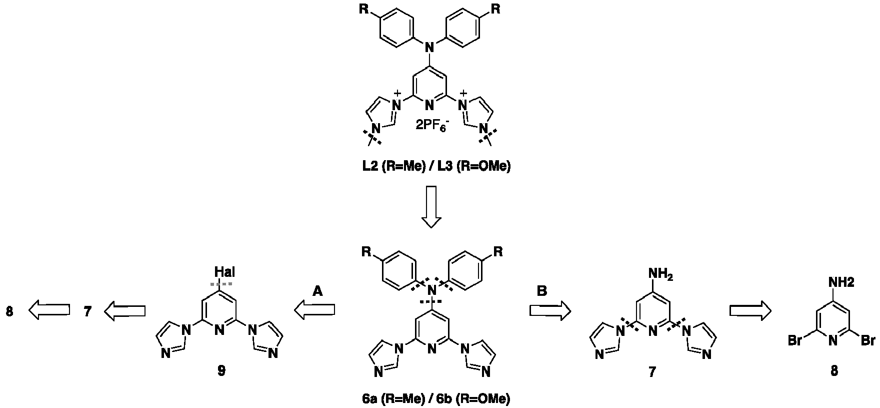

The initial step of the synthesis was accomplished via a copper-mediated CN coupling under basic conditions. The addition of *L*-proline significantly accelerated the reaction and allowed to improve the yield from 34% to 58%. Subsequent Buchwald-Hartwig C-N coupling of the resulting 4-amino-2,6-bisimidazolepyridine, intermediate **7,** with Br-*p-*tolyl/Br-*p*-anisyl was achieved using Pd₂(dba)₃, as catalyst precursor, dialkyl bisaryl phosphine ligands: XPhos for *p*-bromotoluene and similar in structure but less bulky CyJohnPhos for *p*-bromoanisyl with *t*-BuONa as a base. Both reactions proceed slowly, over 5 days in refluxing toluene, and in moderate yields (27-28 %). Mono arylated product was found to be the major product despite extended reaction times. Mono- and bis-arylated products were however possible to separate on a silica column with a mixture of DCM:methanol 97:3 as the eluent. The last step of the ligand synthesis is the derivatization of the unsubstituted nitrogen of the imidazole moieties, such as methylation of imidazoles with Mel in refluxing DMF, which gave the final ligands in a yield of 84-86 % yield after anion exchange. This procedure is exemplified in Scheme 2.

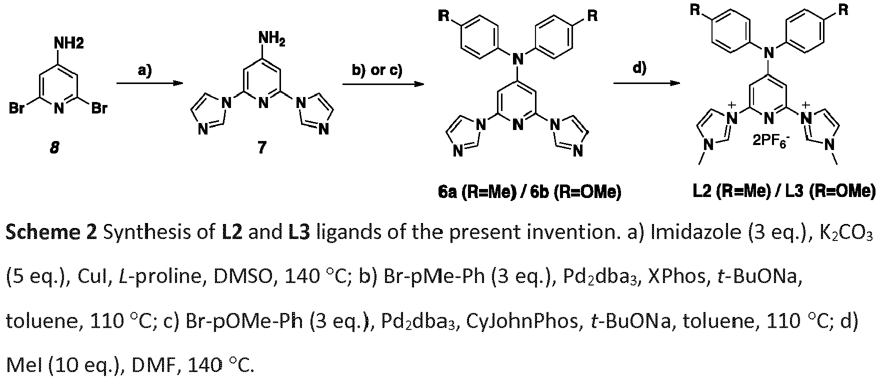

### Heteroleptic Iron(II) NHC complexes: synthesis, purification, characterization

Selective synthesis of heteroleptic Iron(II) *N*-heterocyclic carbenes (Fe-NHCs) was proven to be quite a challenging task. Although, it is well-known in the art that heteroleptic Fe polypyridyls may be achieved when ligands are added to the Fe(halogen)₂ precursor stepwise via formation of FeX(halogen)₂, wherein X represents a first tridentate ligand intermediate, and wherein halogen may be bromine, which undergoes further coordination with a second ligand resulting in [FeXY]halogen₂ complex formation, wherein Y represents a second tridentate ligand. However, there is an issue related to the stability of the Fe(L1)(halogen)₂ intermediate, when NHC is a part of attached tridentate ligand. Bulky substituents seem to play essential role in the stabilization of such species due to the shielding metal center, preventing coordination of second ligand. At the same time, a larger steric bulk of the substituent (for instance seen in *t*-Bu-) has the drawback of affecting the Fe-NHC bond distance in the final complex, which results in a shorter MLCT lifetime. To overcome this problem, a methyl group was introduced to the imidazolium motif compared to the initial design, as the less hindered substituent. Despite the introduction of a smaller substituent, providing less steric hindrance, all attempts to selectively synthesize the desired heteroleptic complexes via *in situ* generation of monotridentate Fe intermediate were unsuccessful. Therefore, a statistical approach was used to make heteroleptic Fe-NHC complexes. This procedure is exemplified in Scheme 3. An obvious disadvantage of the statistical method, shown in Scheme 3 is that it results in three complexes that has to be separated. But because both homoleptic complexes can be used as reference compounds for physico-chemical measurements, it was considered as a benefit.

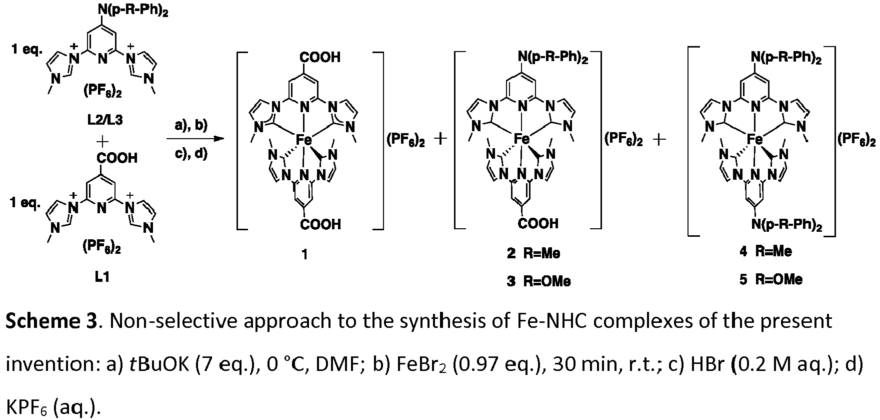

Attempts to optimize the reaction parameters were carried out in order to achieve the best total yield and to increase the content of heteroleptic complexes, such as Examples **2** or **3** of the present invention, in the product mixture. It was found that the extension of the reaction time from 10 to 30 minutes and decreasing the temperature of the carbene formation step from room temperature (rt) to 0 °C, improved the yield of the heteroleptic complexes of Examples **2** and **3** from 2 % to 5 % and from 1 % to 3 % respectively. Mixing of the ligands **L1** and **L2** or **L1** and **L3** in a 1:1 ratio in DMF with subsequent addition of *t*BuOK and FeBr₂ resulted in a mixture of complexes: two homoleptic compounds, i.e. Compound **1** and Example **4** or Compound **1** and Example **5** (red and yellow spots on TLC, respectively), used as reference compounds in the present application, and the desired heteroleptic Examples **2** or **3** (orange spot on TLC). During the work-up step the reaction mixture was acidified with diluted HBr. Then a KPF₆ saturated water solution was added to exchange anion, the precipitate was formed and filtered off. After one of the homoleptic complexes, such as Examples **4** or **5,** was removed, the rest was precipitated out by addition of diethyl ether. Considering the fact that reference Compound **1** is not soluble in ethyl acetate, it was removed via filtration of the suspended product mixture in ethyl acetate. Thus it was also possible to reduce the content of both homoleptic complexes in the product mixture, before column chromatography. This gave a significant advantage of reducing the size of the column and the amount of eluent. The eluent acetone:water:KNO₃ₛₐₜ. in a 10:3:1 ratio gave a nice separation of the complexes on a silica gel, the first yellow fraction contained complex of Examples **4** or **5** (green powder after re-precipitation); the second orange fraction: complex of Examples **2** or **3** (dark-red powder after acidification and re-precipitation); the third one: already reported complex Compound **1** (purple or pink-red powder). The separation was performed on alumina column with ACN:water mixture as an eluent, which also worked as good as silica column for separation but had an advantage of excluding KNO₃, the presence of which could create potential impurity problems. Further repeated re-precipitation (ACN/Et₂O) and repercipitation (slow diffusion, ACN/Et₂O) gave pure samples of the reported complexes, according to NMR. However, elemental analysis indicated the presence of inorganic impurities, presumably KPF₆, which was used in a large excess. To remove the potassium salt, the potassium ions were sequestered with 18-crown-6. When analyzing the resulting complexesit was noticed that both the iron complexes and the KPF₆-18-crown-6 complex were not soluble in Et₂O (dipole moment 1.3) and all solvents below this value. At the same time both complexes were soluble in DCM (dipole moment 1.55) and in all solvents above this value. The search between these values resulted in *t*-BuOMe with a dipole moment 1.4, which could dissolve the impurity but not the iron complexes. The Example **2** or **3** complexes were not soluble, but KPF₆-18-crown-6 complex was dissolved completely and was washed away with the solvent.

Complexes of Examples **2** or **3** and **4** or **5** of the present invention were identified by using standard spectroscopic methods. The formation of complexes is indicated by the absence of the signals for pre-carbene proton in the ¹H NMR spectrum, which had a characteristic chemical shift (*δ* = 9.2 ppm) for the ligand before de-protonation. The characteristic resonance of the carbene carbon appeared at *δ*= 220 ppm in the ¹³C NMR spectrum for all prepared Fe-NHC complexes. The NMR data suggest that all the complexes are diamagnetic. The mass spectrum (MS ESI, positive ions) indicates a signal of half of mass of the complexes (without PF₆ counterions), which is in agreement with dicationic nature of the Fe (II) complexes.

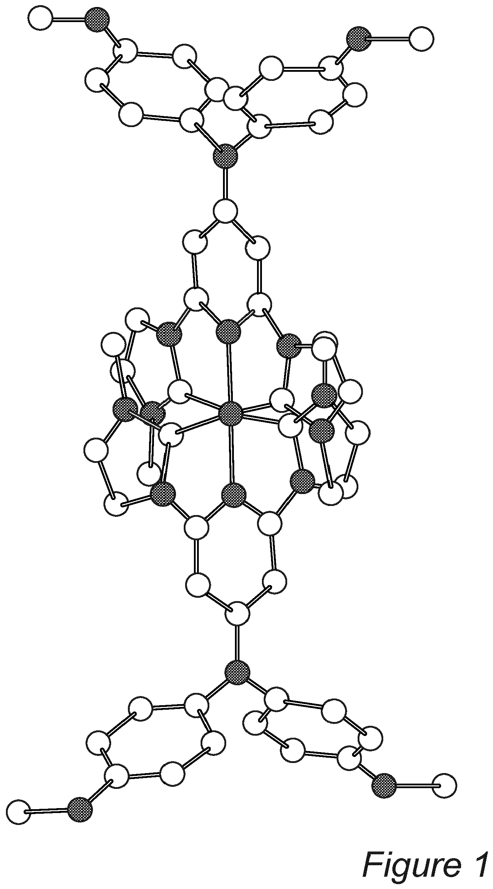

All attempts to grow crystals of complexes comprising carboxylic groups were unsuccessfull. However, crystals of one of the homoleptic complexes, Example **5,** was generated and single-crystal X-ray crystallography proved the octahedral geometry of the comlex of the present invention at the Fe center with slightly distorted angles (Figure 1).

### Cyclic voltammetry, steady-state absorption and spectroelectrochemistry

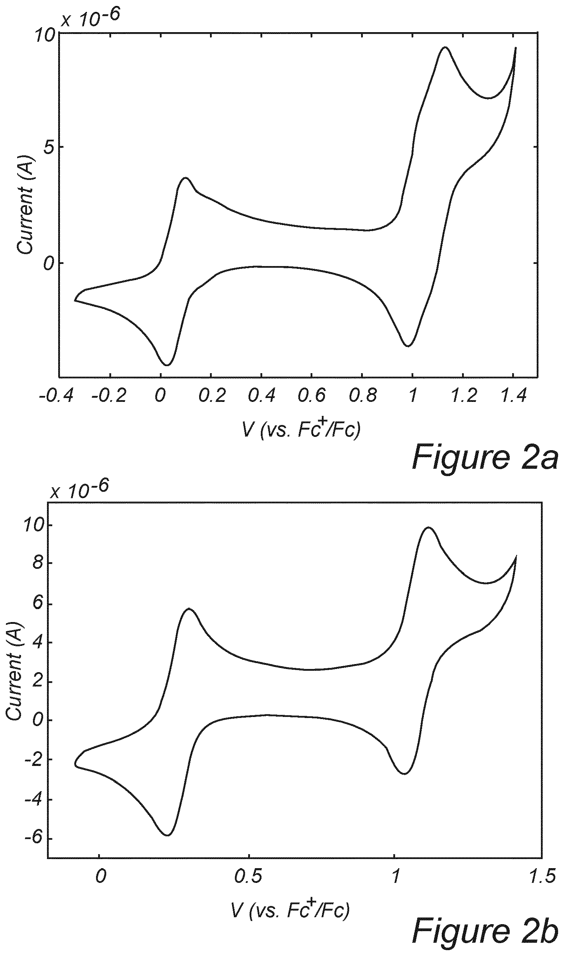

Cyclic voltammetry of [Fe(L2)₂]²⁺ Example **4** (Figure 2a) reveals a reversible one electron wave at *E*_{1/2} = 0.06 V that can be assigned to the Fe^{III/II} couple based on the electronic absorption spectra of [Fe(L2)₂]²⁺ and its one-electron oxidation product. Relative to the complex without the aryl amine moieties, the potential of the Fe^{III/II} couple is lowered by 0.25 V by the electron donating effect of the substituent. The irreversible reductions (DPV peaks at -2.52 and -2.71 V) can be attributed to the ligands while the convoluted irreversible oxidations at about 1.5 V and above are likely to comprise both metal centered oxidation to Fe^{IV} (presumably the DPV peak at 1.49 V) as well as ligand based oxidations. Additional, closely spaced, reversible one-electron waves (1.01 V and 1.09 V) have no counterpart in the voltammograms of the complexes with unsubstituted ligands and can be attributed to the two weakly coupled aryl amine moieties.

Voltammograms of [Fe(L1)(L2)]²⁺ Example **2** (Figure 2b) show two reversible one electron oxidations with half wave potentials of *E*_{1/2} = 0.26 and 1.08 V, respectively. In analogy to the homoleptic aryl amine substituted complex of Example **4,** these waves can be assigned to the Fe^{III/II} couple followed by the oxidation of the aryl amine moiety. The potential of the Fe^{III/II} couple of [Fe(L1)(L2)]²⁺ is however closer to the value found for the unsubstituted parent complex (*E*_{1/2} = 0.31 V) due to the compensating electron withdrawing effect of the carboxylic acid substituent. Also, further irreversible oxidations beyond 1.5 V as well as reductions at -2.38, and -2.78 V (DPV peak potentials) closely resemble the voltammetric data of the homoleptic analogue. These processes are assigned to reductions of the ligands and oxidation to Fe^{IV} convoluted with ligand oxidation.

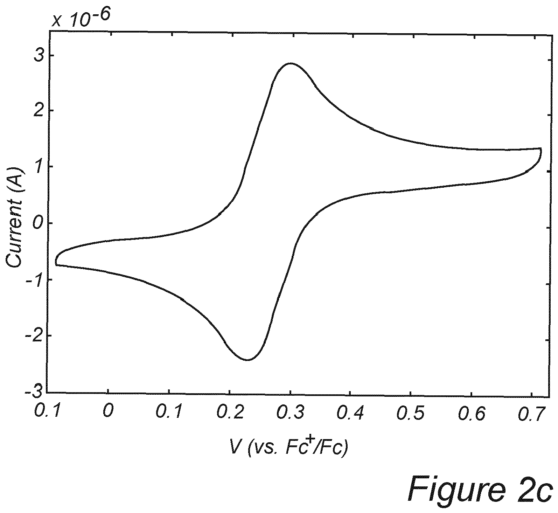

The cyclic voltammetry of [Fe(L1)(L3)]²⁺ Example **3** (Figure 2c) features a reversible one electron oxidation with a half wave potential of *E*_{1/2} = 0.25 V vs. Fc⁺/Fc that can be assigned to the Fe^{III/II} couple. Compared to the related complex with a tolyl amine moiety, the increased electron donating effect of the methoxy substituents has no effect on the potential of the Fe^{III/II} couple. The following oxidation of the aryl amine unit is however shifted to lower potential by 0.12 V by the methoxy substituents. Further irreversible oxidation beyond 1.5 V is typical for Fe-NHC complexes and presumably comprises ligand oxidation as well as further oxidation of the metal center. A first reduction at around -1.7 V is common to [Fe(L1)(L3)]²⁺ and its methyl analogue and possibly involves the carboxylic acid moiety. It is followed by the more NHC ligand reductions around -2.5 V.

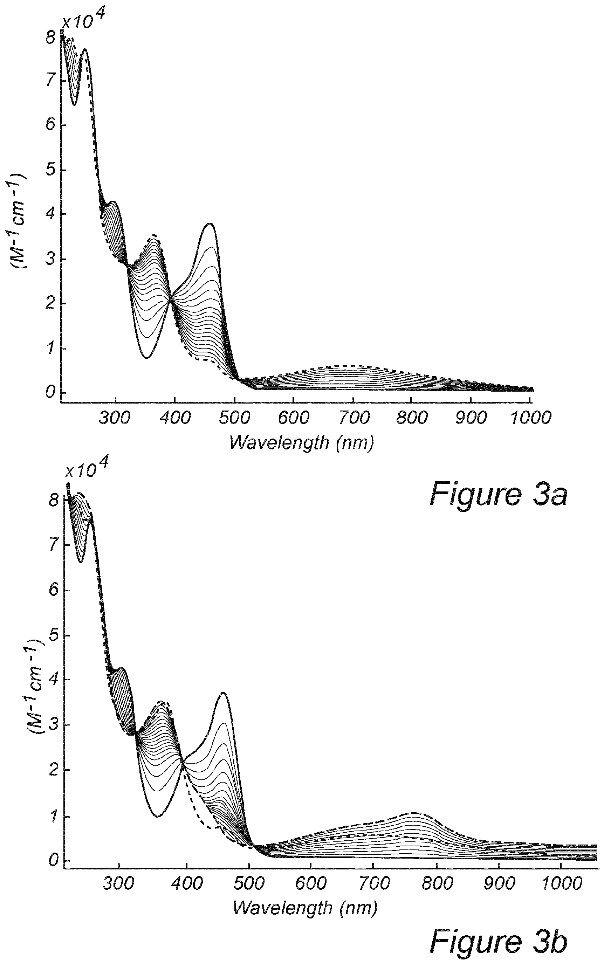

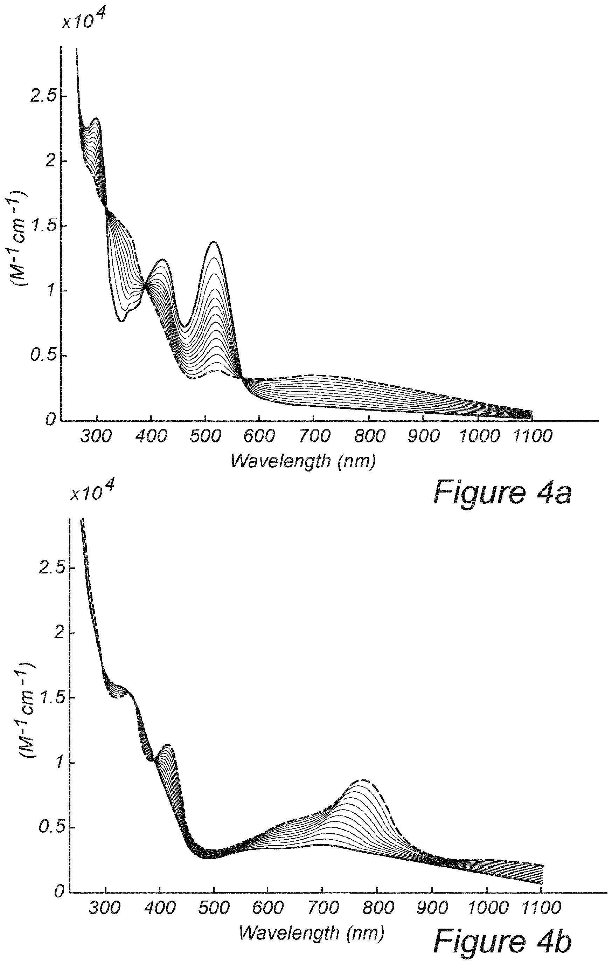

The visible spectrum of [Fe(L2)₂]²⁺ Example **4** (figure 3) features a strong absorption band at 459 nm (ε = 3.9 × 10⁴ M⁻¹ cm⁻¹) which can be assigned to a metal-to-ligand charge transfer (MLCT) transition consistent with the potential difference between the Fe^{III/II} couple and the ligand reduction. Despite the significantly lower potential of the Fe^{III/II} couple, similar MLCT absorption maxima are found for [Fe(L2)₂]²⁺ Example **4** and the unsubstituted parent complex suggesting that also the potential for ligand oxidation is lowered to a similar extent. The MLCT assignment is supported by spectroelectrochemical measurements (Figure 4), wherein holding the potential anodic of the Fe^{III/II} couple results in fully reversible bleaching of the band with isosbestic points at 511, 394, and 320 nm. Furthermore, the resulting low energy absorption peaking at about 680 nm agrees reasonably with the potential difference between the NHC ligand oxidation and the Fe^{III/II} couple allowing for its identification as an LMCT band of the Fe^{III} complex.

Further oxidation at 1.3 V results in additional absorption in the red and near infrared with a peak at 765 nm superposed on the spectrum of the Fe^{III} oxidation state. The product spectrum resembles the well-known spectra of aryl amine cation radicals thereby supporting the assignments of the voltammetric peaks. The MLCT state of Example **4** cannot evolve into a lower energy CT state with the hole eventually located on one of the aryl amine moieties. Such a process would however be feasible for the ligand based electron hole in the LMCT state of [Fe(L2)₂]³⁺.

The MLCT absorption band of [Fe(L1)(L2)]²⁺ Example **2** (Figure 4) is peaking at 518 nm (*ε* = 1.4 × 10⁴ M⁻¹ cm⁻¹) consistent with the potential difference between the Fe^{III/II} couple and the first reduction of the ligands. The assignment is corroborated by the fully reversible bleaching of the MLCT absorption band upon one-electron oxidation at 0.75. The product spectrum is displaying a broad low energy absorption that can be assigned to one or several LMCT transitions of the Fe^{III} complex in reasonable agreement with the difference in potential for ligand oxidation and the Fe^{III/II} couple. As in the homoleptic complex of Example **4,** further oxidation at 1.5 V leads to the emergence absorption bands at 417 and 775 nm that can be assigned to the cation radical of the aryl amine moiety.

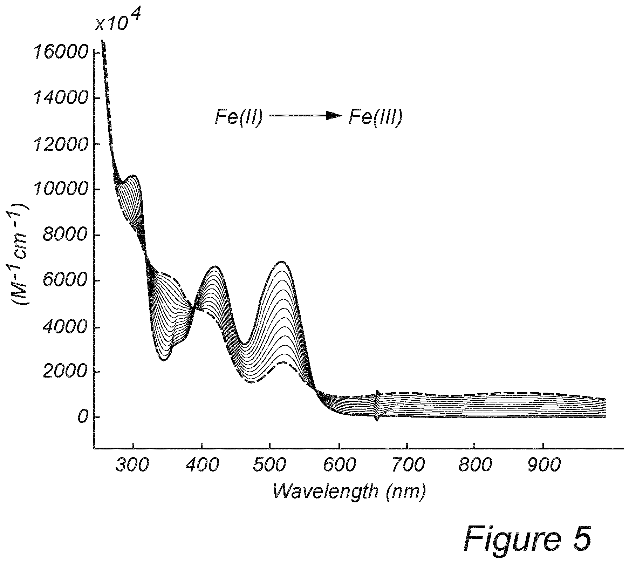

The energy of the MLCT absorption band of [Fe(L1)(L3)]²⁺ Example **3** with its peak at 518 nm (*ε* = 6.7×10³M⁻¹cm⁻¹) is (Figure 5) consistent with the electrochemical data that indicates no effect on the potentials of the Fe^{III/II} couple and reduction of the ligands. Oxidation of the metal center leads to largely reversible bleaching of the MLCT band with clear isosbestic points at 567, 390, and 318 nm; the emerging lower energy absorption is presumably of LMCT origin.

### DFT calculations

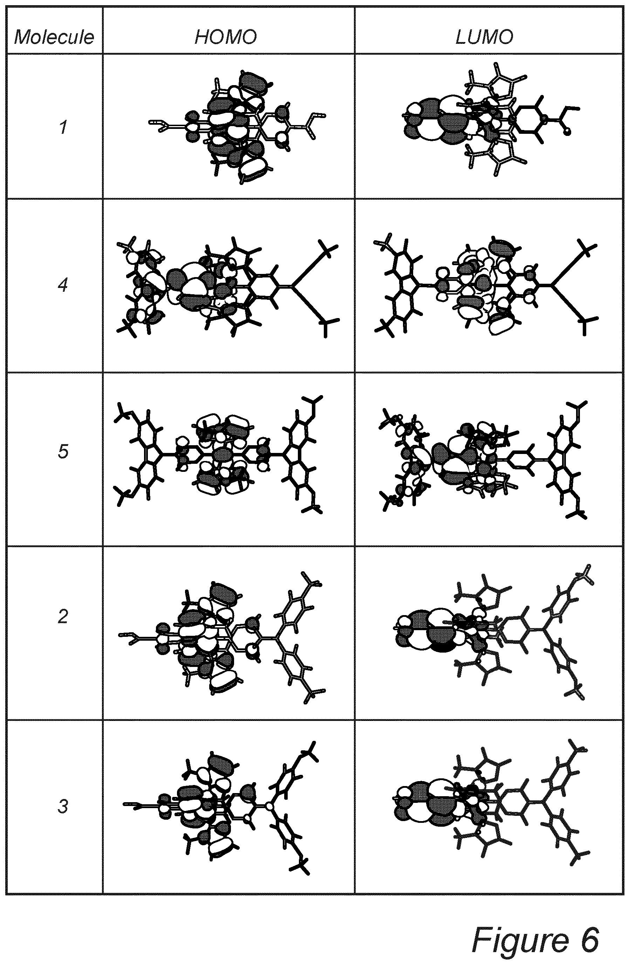

Figure 6 shows a pictoral view of the GS QC calculations. For all molecules in Table 1 the HOMOs are similar: they all feature a mixing of Fe t_{2g} orbital with a π* orbital on the imidazole moieties. Some mixing with the pyridine can also be seen, but inclusion of orbitals coming from the "outer" parts of the ligands is not observed. Due to the large Fe-centered orbital contributions, all HOMOs are considered metal-centered.

For the LUMOs, the orbital contribution from Fe t_{2g} is much less and these orbitals are considered ligand-centered. For the heteroleptic molecules of the present invention, such as Example **2** and Example **3**) the LUMO is always centered on the ligand with the carboxylic group.

### Transient absorption spectroscopy

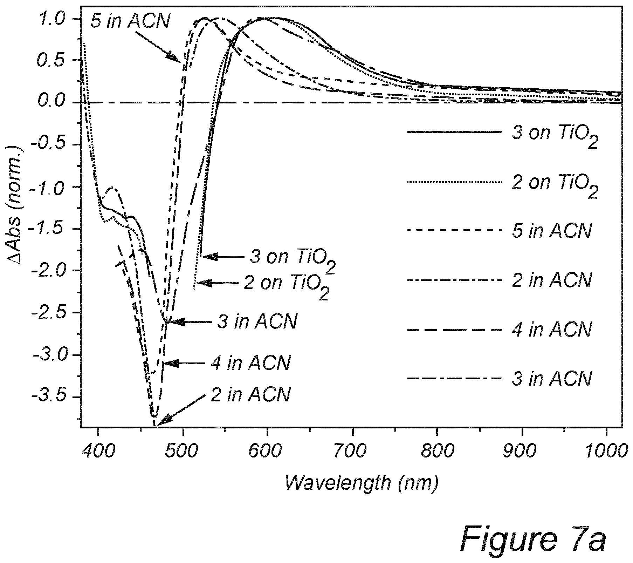

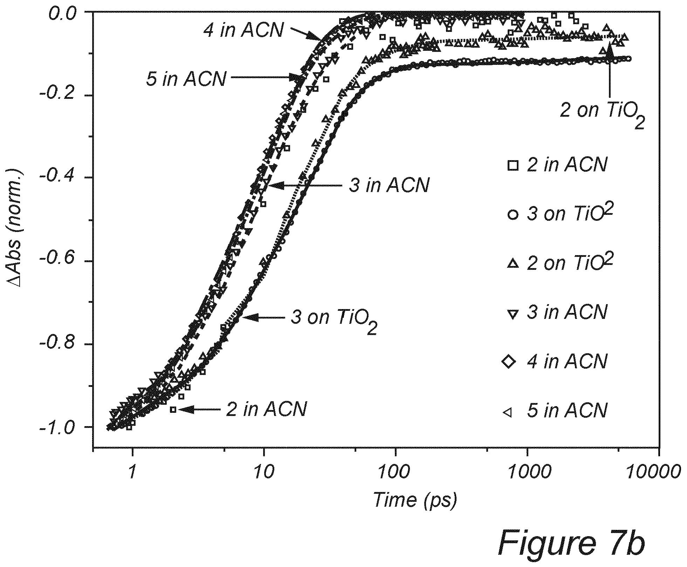

Transient absorption spectroscopy (TAS) was employed to investigate the excited-state properties of Examples **2, 3, 4** and **5** in solution and electron injection from Examples **2** and 3 to TiO₂ nano-porous film. First, the dynamics in acetonitrile solution was investigated in order to distinguish the effects of COOH functionalization and surface immobilization from the actual electron injection. Global analysis (GA) was performed on all measured datasets in order to identify the spectral features of the photo-generated species. Measured spectra and kinetics are shown in Figure 7. Excited wavelength was tuned at 400 nm and at 490 nm to match better the molecule's absorption spectrum. In acetonitrile solution, the molecules display ground state bleach (GSB) and an excited state absorption (ESA), which are similar to the features previously ascribed to the ³MLCT state of other Fe carbene molecules. Global analysis of all the data reveals two decay components, with first one in 3-5 ps range and second dominant component ranging ^{∼}11 to 16 ps depending on particular molecule. All fit components are summarized in Table1. For the molecules substituted with -COOH anchoring group data on TiO₂ were also recorded (Figure 7), where besides slight prolongation of the MLCT lifetime, it may also be observed a pronounced long-lived component, which is not decaying within the time window of the TA experiment (10 ns). This is attributed to the electron injection to the TiO₂. Moreover, the final spectral component (non-decaying) from the global fit resembles closely the shape of the oxidized dye spectrum as known from the spectroelectrochemistry.

Figure 7 (a) shows TAS spectra for all studied molecules recorded 1 ps after excitation pulse. The spectra are corrected for chirp (GVD) with subtracted background. Pump scattering region is omitted for each spectrum. The spectra of Examples **2** and **3** on TiO₂ are noticeably red-shifted, as usually observed upon adsorption to the TiO₂.

Figure 7 (b) shows kinetic traces for all four compounds in acetonitrile solution and for Examples **2** and **3** (possessing anchoring groups) also kinetics as measured upon adsorption to TiO₂ surface. The kinetics are recorded in the GSB region at 450 nm and are normalized to their respective minima. Symbols represent the measured data and solid lines are fits, resulting from the global fit to the data. All data were measured under normal ambient conditions, translating the sample after each scan. Absorption spectra were also checked before and after each experiment to rule out any possible photodegradation. All the decay components are summarized in Table 1. While the solution kinetics look very similar across the studied molecules, Example **2** and Example **3** on TiO₂ differ significantly. These examples do not only consist of additional longer decay components, but also possess distinct non-decaying process, which is assigned to a signal from an oxidized dye. Thus, it has been clearly shown that the electrons are injected from the sensitizer compound to the TiO₂ and that the back recombination is rather long, definitely beyond time resolution of TAS.

**Table 1 Summary of the global analysis of the TA data. The k1 to k4 are exponential decay components and the "nd" stands for non-decaying component which is beyond time resolution of the experiment and was fixed during the fit.**

| Example | k1 | k2 | k3 | k4 |
|---|---|---|---|---|
| **4** | 3.1 ps | 11.2 ps | - | - |
| **5** | 5.6 ps | 16.5 ps | - | - |
| **2** | 3.3 ps | 13.6 ps | - | - |
| **3** | 7.2 ps | 25.5 ps | - | - |
| **2-TiO₂** | 2.3 ps | 17.4 ps | 83.6 ps | - nd |
| **3-TiO₂** | 3.1 ps | 18.6 ps | 40.5 ps | - nd |

### Solar cell fabrication

Generally, the fabrication of solar cells using the compounds of the present invention followed procedures as described in previous reports.

### Solar cell characterization

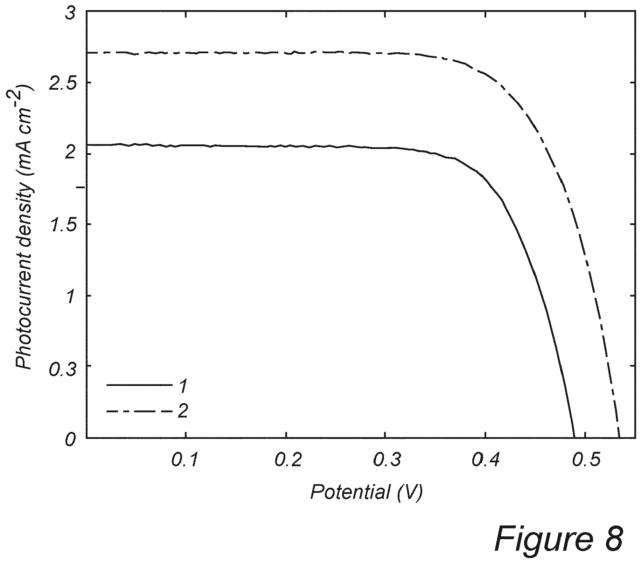

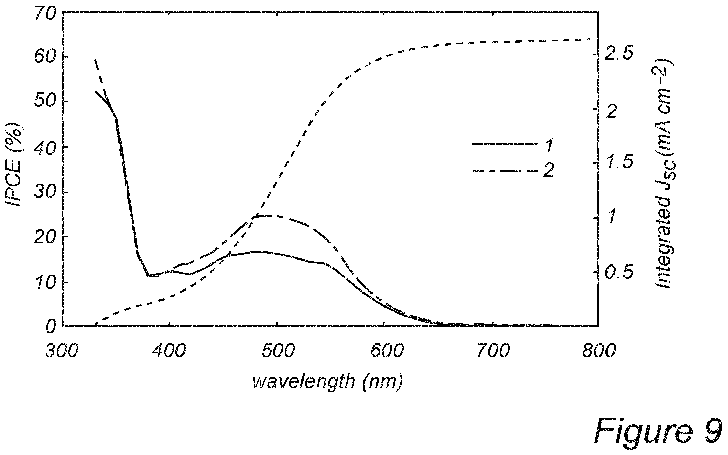

The current-power (J-P) curves of the laboratory solar cell using reference Compound **1** and an example of the present invention, Example **2** as photosensitizers (Figure 8) show that the power output in terms of effect (the area under each curve) is higher for solar cells using Example **2** as a photosensitizer compared to using reference Compound **1** under identical condition. The IPCE curves of the laboratory solar cell using Compound **1** and Example **2** as photosensitizers, respectively, (Figure 9) shows that at all wavelength in the visible spectra, Example **2** is more efficient that Compound **1** in generating electron from the photons irradiating the surface, which is expressed in percentage of (number of electrons generated)/(number of photons hitting the surface). Moreover, as can be seen in Table 2, the maximum voltage (Voc), and maximum current Jsc that could be generated in the laboratory solar cell is higher using Example **2** as a photosensitizer compared to reference Compound **1.** All this results in a higher overall performance PCE (power conversion efficiency) value for Example **2** of the present invention compared to Compound **1** as photosensitizer in the laboratory solar cell. However, the fill factor (FF) is almost identical for Example **2** photosensitizer compared to Compound **1,** in the laboratory solar cell; the reason for this needs to be studied further.

**Table 2 . Solar cells characterics of the fabricated solar cell using either reference Compound 1 or Example 2 of the present invention as photosensitizer.**

| Complex | V_{OC} (V) | J_{SC} (mA cm⁻²) | J_{SC,IPCE} (mA cm₋₂) | FF | PCE (%) |
|---|---|---|---|---|---|
| Compound **1** | 0.49 | 2.06 | 2.00 | 0.73 | 0.73 |
| Example **2** | 0.53 | 2.70 | 2.62 | 0.71 | 1.03 |

| | | | | | |
|---|---|---|---|---|---|
| V_{OC} = open-circuit voltage; J_{SC} = short-curcuit current density; J_{SC} = short-curcuit current density calculated from IPCE data; FF = fill factor; PCE = power conversion efficiency. | | | | | |

### Examples

By way of examples, and not limitation, the following examples identify a variety of compounds pursuant to embodiments of the present invention.

### General experimental procedures

All commercial reagents were used as received, unless otherwise stated. Dry toluene was collected from dry solvent dispenser (MBRAUN SPS-800) and stored over 3 Å MS. Dry DMF was collected from dry solvent dispenser (Innovative technology, PS-micro) and stored over 3 Å MS. Reactions run in room temperature are in the range of 20-23 °C. Metal heating mantels were used to achieve required reaction temperatures. Flash column chromatography was carried out on silica gel column ((ø,h), 60 Å, 230-400 mesh, obtained from Sigma Aldrich) using reagent-grade solvents. Analytical thin-layer chromatography (TLC) was carried out on TLC Silica gel 60 F254 and visualized with a UV-lamp (254 nm). ¹H NMR and ¹³C NMR were recorded at rt on a Bruker Avance II at 400.1 MHz and 100.6 MHz respectively. The spectra were recorded in CDCl₃, MeOH-*d*₄ or Acetonitrile-*d*₃ and the residual solvent signals (7.26/77.16; 3.31/49.00; 1.94/1.32 ppm, respectively) were used as reference. Chemical shifts (*δ*) expressed in parts per million (ppm) and coupling constants (*J*) are reported in Hertz (Hz). The following abbreviations are used to indicate apparent multiplicities: s, singlet; br, broad singlet; d, doublet; dd, doublet of doublets; dq, doublet of quartets; t, triplet; td, triplet of doublets, q, quartet, m, multiplet. High resolution mass spectroscopy was carried out using a Waters - XEVO-G2 QTOF spectrometer using electron spray ionization and was run in positive mode. The TiO₂ paste purchased from Solaronix (Ti-Nanoxide HT, 10^{∼}15 nm particle size). Common solvents including acetonitrile (ACN), ethyl acetate, toluene, Dichlormethane (DCM), methanol, petroleum ether, *tert*-butyl methyl ether and diethyl ether were purchased from Honeywell and used as received. Copper(I) iodide, Pd₂dba₃, K₂CO₃, XPhos, CyJohnPhos and potassium *tert*-butoxide (1 M solution in THF) were purchased from Sigma Aldrich. Imidazole, *L*-proline, 4-bromotoluene, 1-bromo-4-methoxybenzene, iodomethane, hydrobromic acid (48% solution in water), anhydrous iron(II) bromide and were purchased from Acros. 4-Amino-2,6-dibromopyridine was purchased from Apollo Scientific. Potassium hexafluorophosphate was purchased from Alfa Aesar. Precoated Merck silica gel 60 F₂₅₄ plates were used for TLC analysis.

### Ligand L1

2,6-Bis(3-methylimidazolium-1-yl)pyridine-4-carboxylic acid hexafluorophosphate (L1) was synthesized according to the literature procedure by T. Harlang, et al. Nature chemistry, 2015, 7 (11), 883-889.

### Intermediate 7

### 2,6-Bis(imidazol-1-yl)-pyridine-4-amine (7)

2,6-Dibromo-4-amino pyridine (8) (2.50 g, 10 mmol), imidazole (2.06 g, 30 mmol), L-proline (0.23 g, 2 mmol), Cul (0.38 g, 2 mmol), and K2CO3 (6.93 g, 50 mmol) were dissolved in DMSO (12.5 mL). The resulting mixture was heated to 140 0C for 48h under stirring. After cooling to rt, the resulting mixture was diluted with water (250 mL). The reaction mixture was extracted with EtOAc:n-BuOH (9:1) (4x250 mL). The combined organic phases was washed three times with brine, dried over MgSO4, filtered and evaporated to dryness in vacuo. The resulting solid was washed with water giving a yellow filtrate and the 7 as an off white solid (1.30 g, 58%) after drying. 1H NMR (400 MHz, CD3OD): *δ* = 8.48 (s, 2H), 7.80 (s, 2H), 7.12 (s, 2H), 6.70 (s, 2H) ppm. 13C NMR (100.6 MHz, CD3OD): *δ* =161.0, 150.3, 136.4, 130.1, 117.9, 96.0 ppm. MS (HRMS) (m/z): [MH+] calcd. For C11H11N6+ 227.1045; found 227.1042.

### Intermediate 6a

### 2,6-Bis(imidazol-1-yl)-N,N-di-p-tolylpyridine-4-amine (6a)

2,6-Bis(imidazol-1-yl)-4-amino pyridine (7) (51 mg, 0.23 mmol), t-BuONa (65 mg, 0.68 mmol), Pd₂(dba)₃ (11 mg, 0.01 mmol) and 4-bromotoluene (158 mL, 0.92 mmol) were dissolved in toluene (4 mL) and the resulting solution was degased by bubbling Argon. A solution of XPhos (21 mg, 0.044 mmol) in toluene (1 mL) was added dropwise to the reaction mixture. The resulting mixture was heated to 125 °C for 5 days. After cooling to rt, the reaction mixture was filtered, washed with several portions of toluene, and the filtrate was evaporated to dryness in vacuo. The crude product was purified by flash chromatography on silica gel (Ch₂Cl₂:CH₃OH 95:5) yielding **6a** as an off-white solid (25 mg, 28 %). ¹H NMR (400 MHz, CD₂Cl₂): *δ* =8.15 (t, *J*=1 Hz, 2H), 7.47 (t, *J*=1 Hz, 2H), 7.23-7.27 (m, 4H) 7.15-7.19 (m, 4H), 7.07 (t, *J*=1 Hz, 2H), 6.56 (s, 2H), 2.38 (s, 6H) ppm. ¹³C NMR (100.6 MHz, CD₂Cl₂): *δ* = 159.0, 149.5, 142.0, 137.4, 135.4, 131.2, 130.6, 127.3, 116.7, 97.4, 21.2 ppm. MS (ESI-QTOF) (m/z): [MH⁺] calcd. for C25H23N6⁺ 407.19; found 407.30.

### Intermediate 6b

### N,N-Bis(4-methoxyphenyl)-2,6-bis(imidazol-1-yl)-pyridine-4-amine (6b)

2,6-Bis(imidazol-1-yl)-4-amino pyridine (**7**) (934 mg, 4.13 mmol), *t*-BuONa (1192 mg, 12.4 mmol), Pd₂(dba)₃ (190 mg, 0.21 mmol) and CyJohnPhos (145 mg, 0.414 mmol) were dissolved in toluene (225 mL). 4-Bromoanisole (2.1 mL, 17 mmol) was added to the reaction mixture. The resulting mixture was refluxed at 110 °C for 5 days. After cooling to rt, the reaction was filtered on a glass filter (#3), washed with several portions of toluene and the filtrate was evaporated to dryness *in vacuo.* The crude product was purified by gradient flash chromatography on silica gel (CH₂Cl₂:CH₃OH 96.7:3.3 to 90:10) yielding **6b** as an off-white solid (495 mg, 27 %). ¹H NMR (400 MHz, CDCl₃): *δ* = 8.17 (t, *J*=1, 2H), 7.44 (t, *J*=1, 2H), 7.18-7.23 (m, 4H), 7.12 (dd, *J*=2,1 Hz, 2H), 6.94-6.99 (m, 4H), 6.46 (s, 2H), 3.85 (s, 6H) ppm. ¹³C NMR (100.6 MHz, CDCl₃): *δ* = 159.0, 158.5, 149.3, 136.9, 135.2, 130.6, 128.5, 116.4, 115.6, 96.4, 55.7 ppm. MS (ESI-QTOF) (m/z): [MH⁺] calcd. for C25H23N6O2⁺ 439.19; found 439.20.

### Ligand L2

### 2,6-Bis(3-methylimidazol-1-yl)-N,N-di-p-tolylpyridine-4-amine hexafluorophosphate (L2)

To a solution of 2,6-bis(imidazol-1yl)-*N*,*N*-di-p-tolylpyridine-4-amine **(6a)** (199.7 mg, 0.4913 mmol) in DMF (5 mL), Mel (0.31 mL, 4.9 mmol) was added slowly. The resulting mixture was heated to 140 °C for 48 h under stirring. After cooling to rt, KPF₆ (sat. aq. 10 mL) was added to the reaction mixture. The resulting precipitate was filtered off, placed on a glass filter (#4) washed with several portions of water and then with several portions of petroleum ether to give the **L2** as an off-white solid (301 mg, 84 %). ¹H NMR (400 MHz, CD₃CN): *δ* = 9.17-9.20 (m, 2H), 7.93 (t, *J*=2 Hz, 2H), 7.49 (t, *J*=2 Hz, 2H), 7.32-7.36 (m, 4H), 7.22-7.27 (m, 4H), 6.88 (s, 2H), 3.92 (s, 6H), 2.39 (s, 6H) ppm. ¹³C NMR (100.6 MHz, CD₃CN): *δ* = 160.5, 147.3, 141.9, 138.9, 136.2, 132.0, 127.9, 125.6, 120.2, 100.6, 37.5, 21.1 ppm. MS (ESI-QTOF) (m/z): [(L2-2PF₆)²¹] calcd. for C27H28N6²⁺ 218.12; found 218.0.

### Ligand L3

### N,N-Bis( 4-methoxyphenyl)-2,6-bis(3-methylimidazol-1-yl)-pyridine-4-amine hexafluorophosphate (L3)

To a solution of *N*,*N*-bis(4-methoxyphenyl)-2,6-bis(imidazol-1-yl)-pyridine-4-amine (6b) (473 mg, 1.08 mmol) in DMF (5.5 mL), CH₃I (0.67 mL, 11 mmol) was added slowly. The resulting mixture was heated to 145 °C for 48 h under stirring. After cooling to rt, KPF₆ solution (aq. sat., 25 mL) was added to the reaction mixture. The resulting precipitate was filtered off on a glass filter (#4), washed with several portions of water and then with several portions of petroleum ether to give the **L3** as an off white solid (704 mg, 86 % yield). ¹H NMR (400 MHz, CD₃CN): *δ* = 9.20-9.23 (m, 2H), 7.95 (t, *J*=2 Hz, 2H), 7.49 (t, *J*=2 Hz, 2H), 7.29-7.34 (m, 4H), 7.04-7.08 (m, 4H), 6.81 (s, 2H), 3.92 (s, 6H), 3.83 (s, 6H) ppm. ¹³C NMR (100.6 MHz, CD₃CN): *δ* =161.1, 160.1, 147.4, 137.2, 136.2, 129.6, 125.6, 120.3, 116.8, 99.9, 56.3, 37.5 ppm. MS (ESI-QTOF) (m/z): [(L3-2PF₆)²⁺] calcd. for C27H28N6O2²⁺ 234.11; found 234.0.

### Example 2 and Example 4

### (2,6-Bis(3-methylimidazol-2-idene-1-yl)-pyridine-4-carboxylicacid)(2,6-bis(3-methylimidazol-2-idene-1-yl)-N,N-di-p-tolyl-pyridine-amine)iron(II) hexafluorophosphate (2) and bis(2,6-bis(3-methylimidazol-2-idene-1-yl)-N,N-di-p-tolyl-pyridine-amine)iron(II) hexafluorophosphate (4)

To a pre-cooled to 0 °C suspension of 2,6-bis(3-methylimidazol-1-yl)-N,N-di-p-tolylpyridine-4-amine hexafluorophosphate (L2) (151 mg, 0.208 mmol) and 2,6-bis(3-methylimidazolium-1-yl)pyridine-4-carboxylic acid hexafluorophosphate (**L1**) (118 mg, 0.205 mmol) in DMF (4 mL), *t*-BuOK (THF, 1M, 1.3 mL, 1.3 mmol) was added dropwise and the resulting mixture was stirred for 15 min under cooling to 0°C. FeBr₂ (DMF, 2.1 M, 1 mL, 0.21 mmol) was added dropwise to the reaction mixture. The reaction mixture was allowed to reach rt under stirred for 1h. The reaction mixture was acidified with HBr (aq., 1 M, 10 ml) to pH = 2 and KPF₆ (sat. aq. 10 ml) was added. The reaction mixture was extracted with EtOAc (3x50 mL), combined organic phases was dried over MgSO₄ and concentrated in vacuuo. The crude product mixture was further purified by column chromatography (silica gel, acetone:H₂O:KNO₃ sat. aq. solution = 20:3:1). Products were separated into individual fractions and a subsequent acidification(only for **2**)/ KPF₆ re-precipitation afforded **2** and **4.** Resulting precipitates were collected by filtration on a glass filter (#4), rinsed with ice cold water and repeatedly re-precipitated from CH₃CN/Et₂O mixture. The resulting precipitates were dissolved in a minimal amount of acetonitrile and recrystallized by slow diffusion of Et₂O. Products were dried *in vacuo* to yield **2** as an orange-red solid (11 mg, 5 % yield) and **4** as an green-yellow solid (30 mg, 12 % yield).

### Example 2

### (2,6-Bis(3-methylimidazol-2-idene-1-yl)-pyridine-4-carboxylicacid)(2,6-bis(3-methylimidazol-2-idene-1-yl)-N,N-di-p-tolyl-pyridine-amine)iron(II) hexafluorophosphate (2)

¹H NMR (400 MHz, CD₃CN): *δ* = 8.22 (s, 2H), 8.15 (d, *J*=2 Hz, 2H), 7.70 (d, *J*=2 Hz, 2H), 7.26-7.32 (m, 4H), 7.32-7.38 (m, 4H), 7.06 (d, *J*=2 Hz, 2H), 7.00 (s, 2H), 6.85 (d, *J*=2 Hz, 2H), 2.77 (s, 6H), 2.33-2.45 (m, 12H) ppm. Elemental analysis: Calc. for (C41H39F12FeN11O2P2) C, 46.30; H, 3.70; N, 14.49; found C, 46.26; H, 3.88; N, 14.48. MS (ESI-QTOF) (m/z): [(**2**-2PF₆)²⁺] calcd. for C41H39FeN11O2²⁺ 386.6305; found 386.6319.

### Example 4

### bis(2,6-bis(3-methylimidazol-2-idene-1-yi)-N,N-di-p-tolyi-pyridine-amine)iron(ll) hexafluorophosphate (4)

¹H NMR (400 MHz, CD₃CN): *δ* = 7.68 (d, *J*=2 Hz, 2H), 7.31 (d, *J*=8.8 Hz, 4H), 7.24 (d, *J*=8.8 Hz, 4H), 6.95 (s, 2H), 6.91 (d, *J*=2 Hz, 2H), 2.67 (s, 6H), 2.39 (s, 6H) ppm. Elemental analysis: Calc. for ((C54H52F12FeN12O2P2)^{∗}0.75(C4H10O)) C, 54.21; H, 4.69; N, 13.14; found C, 54.18; H, 4.79; N, 13.19. MS (ESI-QTOF) (m/z): [(**4**-2PF₆)²⁺] calcd. for C54H52FeN12O2²⁺ 462.1885; found 462.1894.

### Example 3 and Example 5

**(2,6-Bis(3-methylimidazol-2-idene-1-yl)-pyridine-4-carboxylicacid)(*N,N*-bis(4-methoxyphenyl)-2,6-bis-(3-methylimidazol-2-idene-1-yl)-pyridine-amine)iron(II) hexafluorophosphate (3)** and **bis(*N*,*N*-bis(4-methoxyphenyl)-2,6-bis-(3-methylimidazol-2-idene-1-yl)-pyridine-amine)iron(II) hexafluorophosphate (5)** To a pre-cooled to 0 °C suspension of *N*,*N*-bis(4-methoxyphenyl)-2,6-bis(3-methylimidazolium-1-yl)-pyridine-4-amine hexafluorophosphate (L3) (200.3 mg, 0.264 mmol) and 2,6-bis(3-methylimidazolium-1-yl)pyridine-4-carboxylic acid hexafluorophosphate (L1) (151.6 mg, 0.264 mmol) in DMF (4 mL), *t*-BuOK (THF, 1 M, 1.6 mL, 1.6 mmol) was added dropwise. The resulting reaction mixture was stirred for 15 min under cooling to 0 °C. FeBr₂ (DMF , 0.27 M, 1M, 0.27 mmol) was added dropwise to the reaction mixture. The resulting mixture was allowed to warm to rt and was stirred for 1 h. The reaction mixture was acidified with HBr (aq., 1 M, 10 ml) to pH = 2 and KPF₆ (sat. aq. 10 ml) was added. The reaction mixture was extracted with EtOAc (3x50 mL). The combined organic phases was dried over MgSO₄ and concentrated *in vacuo.* The crude product mixture was further purified by column chromatography (silica gel, acetone:H₂O:KNO₃ sat. aq. solution = 20:3:1). Thus all products were separated and a subsequent acidification (only for **3**) / KPF₆ re-precipitation afforded **3** and **5.** The resulting precipitates were collected by filtration on a glass filter (#4), rinsed with ice cold water and repeatedly re-precipitated from CH₃CN/Et₂O mixture. The resulting precipitates were dissolved in a minimal amount of acetonitrile and recrystallized by slow diffusion of Et₂O. Products were dried *in vacuo* to yield **3** as an orange-red solid (9 mg, 3 % yield) and **5** as an green-yellow solid (30 mg, 9 % yield).

### Example 3

### (2,6-Bis(3-methylimidazol-2-idene-1-yl)-pyridine-4-carboxylicacid)(N,N-bis(4-methoxyphenyl)-2,6-bis-(3-methylimidazol-2-idene-1-yl)-pyridine-amine)iron(II) hexafluorophosphate (3)

¹H NMR (400 MHz, CD₃CN): *δ* = 8.22 (s, 2H), 8.14 (d, *J*=2 Hz, 2H), 7.72 (d, *J*=2H, 2H), 7.34-7.41 (m, 4H), 7.04-7.11 (m, 6H), 6.91 (s, 2H), 6.84 (d, *J*=2 Hz, 2H), 3.85 (s, 6H), 2.77 (s, 6H), 2.38 (s, 6H) ppm. Elemental analysis: Calc. for (C41H39F12FeN11O4P2*2(C4H10O)*1.5(C2H3N))C, 48.79; H, 4.81; N, 13.17; found C, 48.79; H, 5.03; N, 13.18.

### Example 5

### bis(N,N-bis(4-methoxyphenyl)-2,6-bis-(3-methylimidazol-2-idene-1-yl)-pyridine-amine)iron(II) hexafluorophosphate (5)

¹H NMR (400 MHz, CD₃CN): *δ* = 7.70 (d, *J*=2 Hz, 2H), 7.33 (d, *J*=8.8 Hz, 4H), 7.05 (d, *J*=8.8 Hz, 4H), 6.90 (s, 2H), 6.85 (d, *J*=2 Hz, 2H), 3.84 (s, 6H), 2.66 (s, 6H) ppm.

### Sensitization procedure

The TiO₂ paste was doctor-bladed on different substrates for the preparation of the TiO₂ nano-films. For samples used for TAS, glass microscope slides were used as the substrate. The printed slides were coated in the oven following the next temperature mode: for 10 min at 150 °C and for 30 min at 450 °C. After controlled cooling overnight to 80 °C, the TiO₂ films were immersed into a 0.5 mM MeCN solution of the sensitizing dye for 24 h at room temperature. It was then rinsed with acetonitrile several times and dried under a stream of nitrogen gas.

### DFT calculations

A singlet ground state of the molecule was optimized by density functional theory calculations using the program Gaussian, functional B3LYP* and basi set 6-311G(d, p) modelled in the solvent acetonitrile. Also, a triplet structure was optimized by the same procedure. Time-dependent density functional theory calculations was used to calculate the 30 lowest singlet to singlet excitations.

### Cyclic voltammetry, steady-state absorption and spectroelectrochemistry

Cyclic voltammetry, differential pulse voltammetry and controlled-potential electrolysis were performed using an Autolab PGSTAT302 potentiostat with a GPES electrochemical interface (Eco Chemie). The working electrode was a glassy carbon disc (1.6 mm diameter) that was freshly polished with alumina paste prior to all measurements. A glassy carbon rod in a compartment separated from the bulk solution by a fritted disk was used as counter electrode. The reference electrode was a non-aqueous Ag⁺/Ag electrode (0.010 M AgNO₃ in acetonitrile) that was calibrated with reference to the ferrocenium ion/ferrocene couple (Fc^{+/0}). All solutions were prepared from dry acetonitrile (Sigma-Aldrich, spectroscopic grade, dried with MS 3 Å) with 0.1 M tetrabutylammonium hexafluorophosphate (Fluka, electrochemical grade) as supporting electrolyte that was dried in vacuo at 85° C.

UV-Vis spectroelectrochemical experiments were performed in a custom build quartz glass cell (1 mm optical path length) using a platinum mesh as the working electrode and the same counter and reference electrodes used for voltammetry. Spectra were recorded on an Agilent 8453 diode array spectrophotometer.

### Transient Absorption Spectroscopy

Transient absorption (TA) spectroscopy was performed using an in-house build setup. Basis of this setup is a Spitfire Pro XP (Spectra Physics) laser amplifier system that produces ∼80 fs pulses at a central wavelength of 796 nm at 1 kHz repetition rate. The amplifier output divided into two parts that each pump a collinear optical parametric amplifiers (TOPAS-C, Light Conversion). One of the TOPAS generates the pump beam (525 nm), while the other one generates a NIR beam (1350 nm) that is focused onto a 5 mm CaF₂ crystal to generate a supercontinuum probe beam. The delay between pump and probe beams is introduced by a computer-controlled delay stage (Aerotech) placed in the probe beam's path. After supercontinuum generation the probe pulses are split into two parts: the former being focused to ∼100 µm spot size and overlapping with the pump pulse in the sample volume, and the latter serving as a reference. After passing the sample the probe beam is collimated again and relayed onto the entrance slit of a prism spectrograph. The reference beam is directly relayed on said spectrograph. Both beams are then dispersed onto a double photodiode array, each holding 512 elements (Pascher Instruments). The intensity of excitation pulses was set to 1 mW corresponding to ^{∼}1014 photons per pulse per cm2 and spot-size ratio of pump- and probe-pulse was ^{∼}1:50. Mutual polarization between pump and probe beams was set to the magic angle (54.7°) by placing a Berek compensator in the pump beam. Time-resolution of the setup after dispersion correction is estimated to be ≤150 fs.

Sample solutions were filled in 1 mm optical path length cuvettes (Hellma - Optical Special Glass) and measurements performed at room temperature. To check for stability of the sample steady-state absorption spectra were measured before and after TA experiments. Before analysis the measured data were corrected for group velocity dispersion (GVD - "chirp") using in-house software.

### Solar cell fabrication

Generally, the fabrication of solar cells using the compounds of the present invention followed procedures that are common in the art of solar cell fabrication. On cleaned (RBS solution, water, ethanol, UV-ozone) Nippon sheet glass (Pilkington, St. Helens, UK), 10 Ω sheet resistance, a dense TiO₂ layer was deposited via spray pyrolysis at 450 °C from a 0.2 M titanium tetraisopropoxide, 2 M acetylacetone solution in isopropanol. Subsequently, 0.25 cm² (0.5 cm x 0.5 cm) TiO₂ photoanodes were screen-printed (Seritec Services SA, Corseaux, Switzerland) from DSL 30 NRD-T (Dyesol/ GreatCellSolar, Queanbeyan, Australia) colloidal (30 nm) TiO₂ paste (18 µm). After brief drying at 120 °C, a scattering layer (Dyesol/GreatCellSolar WER2-0, 400 nm) was screen-printed onto of the mesoporous film (5 µm), followed by gradual heating towards a 30 minute sintering step at 450 °C. The substrates were post-treated with a 40 mM aqueous TiCl₄ solution for 30 min at 70 °C and then sintered again at 450 °C for 30 min. After cooling, the titania films were immersed into the dye solutions for 16h, which were prepared as follows; 0.5 mM of respective sensitizer in acetonitrile, chenodeoxycholic acid was added to the dye solution either in 0.1 mM or 0.4 mM concentration. Platinized counter electrodes were fabricated through dropcasting of a 5 mM solution of aqueous H₂PtCl₆ onto predrilled TEC7 glass followed by 30 minutes of sintering at 400 °C. The redox electrolyte solution contained 0.1 M LiI, 0.05 mM I₂ and 0.6 M 1,2-dimethyl-3-propylimidazolium iodide in 3-Methoxypropionitrile. The cells were assembled using ThreeBond (Dusseldorf, Germany) 3035B UV glue and cured with a CS2010 UV-source (Thorlabs, Newton, NJ, USA). The electrolyte was vacuum-injected through a hole in the counter electrode which was then sealed with a thermoplastic film and a glass cover slip.

### Solar cell characterization

Current-Voltage measurements were carried out in ambient air under AM 1.5G illumination using a Sinus-70 solar simulator (Wavelabs, Leipzig, Germany). A 2400 source meter (Ossila, Sheffield, UK) was used to assess solar cell performance (20 mV s⁻¹). After calibration with a certified silicon reference cell (Frauenhofer ISE, Munich, Germany), a mask was employed to confine the active solar cell area to 0.16 cm².

IPCE spectra were recorded with an ASB-XE-175 xenon light source (10 mW cm⁻²) (Spectral Products, Putnam, CT, USA) and a CM110 monochromator (Spectral Products, Putnam, CT, USA). The photocurrent was measured with a U6 digital acquisition board (LabJack, Lakewood, CO, USA). The setup was calibrated with a certified silicon reference cell (Frauenhofer ISE, Munich, Germany). Photocurrents were integrated based on the spectral distribution of sunlight.

## Claims

1. A compound of formula I: 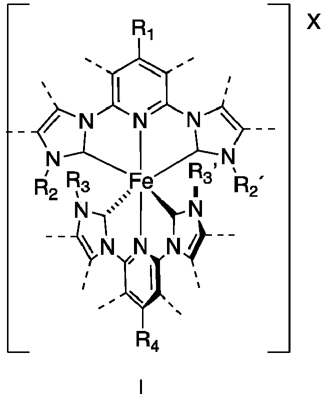 wherein
R₁ is independently selected from alkyl, alkenyl, alkynyl, aryl, heteroaryl, amino, alkoxy, aryloxy, heteroaryloxy, carbonyl, ester, or amide;
each R₂, R_{2'}, R₃, and R_{3'} are independently selected from straight alkyl, branched alkyl, aryl or heteroaryl; preferably R₂ and R_{2'} represents methyl; preferably R₃ and R_{3'} represents methyl.
R₄ is independently selected from alkyl, alkenyl, alkynyl, aryl, heteroaryl, amino, alkoxy, aryloxy, heteroaryloxy, carbonyl, ester, amide, carboxylic acid, phosphonic acid, cyanate or isocyanate, boronic acid; and anions or cations thereof;
X is selected from two mono-anions or one di-anions; preferably selected from (PF₆)₂, (BF₄)₂, (BPh₄)₂, SO₄; and
each dashed bond is independently selected from fused aryl; fused heteroaryl; or
substituent selected from hydrogen alkyl, cyclyl, heterocyclyl, alkenyl, alkynyl, aryl, heteroaryl, amino, alkoxy, aryloxy, heteroaryloxy, carbonyl, ester, amide, carboxylic acid, nitro, or halogen; preferably said dashed bond is hydrogen.

2. The compound according to claim 1, wherein
R₁ represents 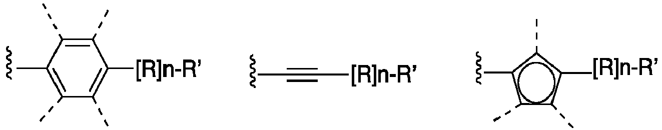 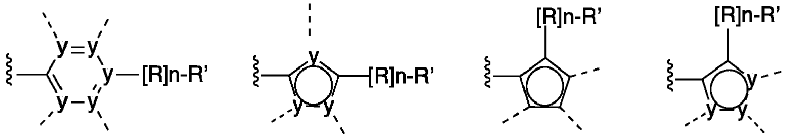 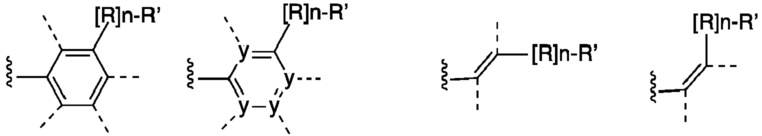 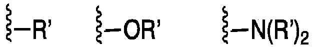
R' is independently selected from alkyl, alkenyl, alkynyl, aryl, heteroaryl, amino, alkoxy, aryloxy, heteroaryloxy, carbonyl, ester, or amide;
R₄ represents 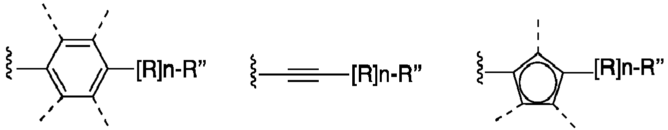 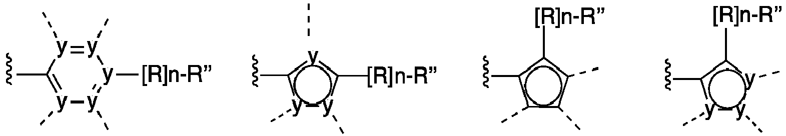 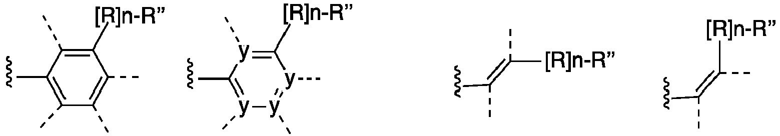 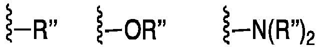
R" is independently selected from alkyl, alkenyl, alkynyl, aryl, heteroaryl, amino, alkoxy, aryloxy, heteroaryloxy, carbonyl, ester, amide, carboxylic acid, phosphonic acid, cyanate or isocyanate, boronic acid; and anions or cations thereof;
n is an integer number between 0-24 of optionally selected R;
R is optionally selected from 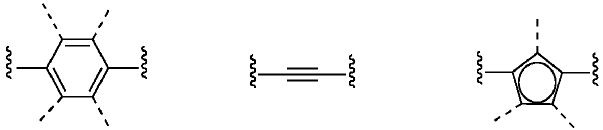 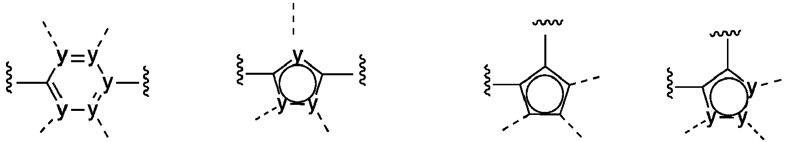 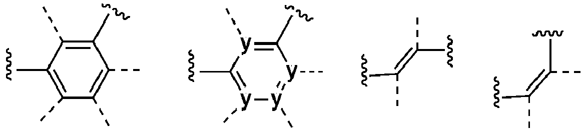
each wavy line denotes connection points to other optionally selected R, R' or R";
each dashed bond is independently selected from fused aryl; fused heteroaryl; or
substituent selected from hydrogen, alkyl, cyclyl, heterocyclyl, alkenyl, alkynyl, aryl, heteroaryl, amino, alkoxy, aryloxy, heteroaryloxy, carbonyl, ester, amide, carboxylic acid, nitro, or halogen; and
y is independently selected from C, N, O, S and Se.

3. The compound according to claim 1 or 2, wherein R₁ is selected from optionally substituted (C₁-C₂₄)alkyl, alkenyl, alkynyl, (C₆-C₂₄)aryl, (C₃-C₂₀)heteroaryl, O(C₁-C₂₄)alkyl, O(C₆-C₂₄)aryl, O(C₃-C₂₀)heteroaryl, NH(C₁-C₂₄)alkyl, and N[(C₁-C₂₄)alkyl]₂, NH(C₆-C₂₄)aryl, N[(C₆-C₂₄)aryl]₂, NH(C₃-C₂₀)heteroaryl, N[(C₃-C₂₀)heteroaryl]₂.

4. The compound according to any of the previous claims, wherein R₄ is selected from carboxylic acid, phosphonic acid, cyanate or isocyanate, boronic acid; and anions or cations thereof.

5. The compound according to any of the previous claims, wherein R₁ is selected from optionally substituted (C₁-C₂₄)alkyl, alkenyl, alkynyl, (C₆-C₂₄)aryl, (C₃-C₂₀)heteroaryl, O(C₁-C₂₄)alkyl, O(C₆-C₂₄)aryl, O(C₃-C₂₀)heteroaryl, NH(C₁-C₂₄)alkyl, and N[(C₁-C₂₄)alkyl]₂, NH(C₆-C₂₄)aryl, N[(C₆-C₂₄)aryl]₂, NH(C₃-C₂₀)heteroaryl, N[(C₃-C₂₀)heteroaryl]₂; and; and R₄ is selected from carboxylic acid, phosphonic acid, cyanate or isocyanate, boronic acid; and anions or cations thereof.

6. The compound according to any of the previous claims, wherein R₁ is selected from optionally substituted N[(C₆-C₂₄)aryl]₂ and R₄ is selected from carboxylic acid or phosphonic acid; and anions or cations thereof; preferably R₁ represents optionally substituted N[(C₆-C₂₄)aryl]₂ and R₄ is CO₂H; preferably R₁ is N(p-methylphenyl)₂ or N(p-methoxyphenyl)₂, and R₄ is CO₂H.

7. The compound according to any of the previous claims, wherein R₁ represents an electron donating group.

8. The compound according to any of the previous claims, wherein R₄ represents an electron accepting group.

9. The compound according to any of the previous claims, wherein said compound is (2,6-Bis(3-methylimidazol-2-idene-1-yl)-pyridine-4-carboxylicacid)(2,6-bis(3-methylimidazol-2-idene-1-yl)-N,N-di-p-tolyl-pyridine-amine)iron(II) hexafluorophosphate or (2,6-Bis(3-methylimidazol-2-idene-1-yl)-pyridine-4-carboxylic acid)(N,N-bis(4-methoxyphenyl)-2,6-bis-(3-methylimidazol-2-idene-1-yl)-pyridine-amine)iron(II) hexafluorophosphate.

10. The compound according to claim 1, wherein said compound is bis(2,6-bis(3-methylimidazol-2-idene-1-yl)-N,N-di-p-tolyl-pyridine-amine)iron(II) hexafluorophosphate or bis(N,N-bis(4-methoxyphenyl)-2,6-bis-(3-methylimidazol-2-idene-1-yl)-pyridine-amine)iron(II) hexafluorophosphate.

11. The compound according to any of the previous claims, wherein said compound is a photosensitizer and/or a photocatalyst.

12. A device comprising the compound according to claims 1-11.

13. The device according to claim 12, wherein it said compound is conjugated to a semiconducting surface or particle; preferably the semiconducting surface or particle is of TiO₂ or NiO.

14. The device according to claim 12 or 13, wherein said device is a solar cell, water oxidation catalyst, proton reduction catalyst, carbon dioxide reduction catalyst, or photoredox catalyst.

15. Use of a compound according to claims 1-11 in a solar cell, water oxidation catalyst, proton reduction catalyst, carbon dioxide reduction catalyst, or photoredox catalyst.
